# EUROPEAN PATENT SPECIFICATION

(11) **EP 1 668 450 B1**
(45) Date of publication and mention of the grant of the patent: **07.07.2010**
(21) Application number: 04784053.3
(22) Date of filing: 15.09.2004
(51) Int. Cl.: H02J 3/14, H02J 13/00, G05B 13/02, G05F 1/70, G01R 21/133

(54) **WIDE-AREA ELECTRICAL DEMAND AND SUPPLY MANAGEMENT**
GROSSFLÄCHIGE VERWALTUNG VON STROMBEDARF UND -ANGEBOT
GESTION DE L'OFFRE ET DE LA DEMANDE EN ELECTRICITE SUR UNE ZONE ETENDUE

(30) Priority: 16.09.2003 US 662940
(43) Date of publication of application: 14.06.2006
(73) Proprietor: ETG International LLC, New York, NY 10012 (US); Heat Timer Corporation, Fairfield, NJ 07004 (US)
(72) Inventor: CHEN, Kimball C., New York, NY 10128 (US); EVANS, Alexander W., New York, NY 10012 (US); Shprecher, Daniel E., Highland Lakes, NJ 07422 (US)
(74) Representative: Plougmann & Vingtoft A/S
(86) International application number: PCT/US2004/030063
(87) International publication number: WO 2005/029243

(56) References cited:
- WO-A-02/07365
- WO-A-98/30912
- JP-A- 5 316 650
- US-A1- 2003 063 723
- US-B1- 6 473 744
- US-B1- 6 519 509
- US-B1- 6 553 418

## Description

### FIELD OF THE INVENTION

The present invention relate generally to controlling, monitoring and managing remote devices and, more particularly to, methods and systems for remotely adjusting states and/or characteristics of the remote devices for reducing demand/consumption and/or adding to the resource supply based on user defined data, external data and/or other information relevant in assessing demand, supply and other events/conditions.

### BACKGROUND OF THE INVENTION

The reliability and availability of energy resources relative to demand has been a worldwide public and private sector concern. Aggregate demand has risen faster than supply in most states and countries, resulting in falling reserve levels and, increasingly, severe shortages and outages. Because it is not practical to store electrical energy, electricity shortages manifest as brownouts and blackouts that impose significant costs to business, consumers, and society. Short of actual brownouts and blackouts, shortages also cause spot market prices to spike wildly, imposing further excessive costs on producers and consumers alike.

Increasing energy generation and transmission on a centralized basis is difficult, and sometimes impossible. Adding to the long-term energy supply is subject to significant construction costs, environmental issues, infrastructural and logistic complexities, capital-raising challenges, regulatory hurdles, social resistance, and time barriers associated with adding generation and transmission capacity.

Power supply and distribution are themselves vulnerable to interruptions, failures and outages. Equipment failures and overloads, shortages of inputs (such as river water for cooling or for hydroelectric power generation, wind for wind turbines), terror and hacker attacks, and other factors can disrupt the availability of existing supply, often with short or no notice.

Power demand varies daily, weekly, monthly, seasonally and yearly. The demand may be for air conditioners, electric heaters, lighting fixtures as well as other appliances and equipment. For most commercial and general use, there is no practical substitution for it. Yet, the demand for such resources has increased faster than supply for many years, and even for decades in some regions. Power demand is also highly variable over short periods, affected by many factors including outdoor temperature. A heat wave or cold snap can result in significant increases in demand. As spare supply capacity reaches dangerously low levels while both moment-to-moment supply and demand are volatile, prices become high and unstable, and the risk of brownouts and blackouts increases sharply.

Excessive resource demand, reduced resource supply, and their combination lead to shortages. For most resources, such shortages lead to extreme market price spikes, as with natural gas; resource quality problems, as with the water supply; and inaccessibility to the resource, leading to loss of associated economic production and, sometimes, loss of life, as with electrical energy. This problem is exacerbated for electrical power, because there is no presently viable mechanism whereby electricity may be stored. Electricity price spikes of a factor of ten are common, and blackouts are increasing in frequency and severity worldwide.

In a resource distribution system such as the electrical power grid, responses to shortages and shortage risks have been addressed with costly standby generating capacity, with customer-disrupting rotating blackouts and brownouts, and with requests by suppliers for large users to idle their production facilities temporarily to reduce peak demand and/or to activate their own, capital-intensive power-generating equipment.

In regard to this user-participation approach to mitigating shortages, as long as the number of such large users has been small-on the order of ten to a hundred-a manual process has been practical for electrical system operators to help balance demand and supply on relatively short notice in the face of demand spikes or supply interruptions. However, these processes' lack of time-efficiency and scalability limits their effectiveness in averting major outages and, secondarily, in reducing extreme price volatility along the supply chain as peak demand approaches the limit of supply.

Providers of resources, such as power generation, transmission, and distribution companies and other utilities, have limited, or no, access to the right information at the right time to effectively influence how energy is consumed by their customers. At best, utilities may have near-real-time information concerning power consumption only of an entire community or large subsection thereof. More detailed information is generally readily available only monthly, when bills are being prepared.

This lack of detailed, real-time and near-real-time information about the nature and amount of demand and standby supply under the control of end-users, and the lack of ability to influence or control it effectively, when needed, presents a significant challenge to resource providers in balancing supply and demand, whether to predict shortages, solve immediate problems, avert future outages, reduce outage risks, stabilize wholesale and other prices, redistribute demand over time, or any other beneficial objective.

Suppliers have very limited mechanisms for influencing the demand for their resources over short periods. It is extremely problematic to detect actual or potential near-term shortages within predefined areas; to communicate useful and timely information to the correct users about them, numbering in the thousands or millions; to assure that an appropriate response of reducing demand, adding to supply, or both, occurs in a rapid, manageable, and auditable manner; and then to assure an orderly and manageable return to normalcy.

The same lack of information, influence and control that handicaps suppliers and distributors also handicaps their customers. It is extremely difficult for them to access the necessary resource-related information to take charge of their own demand, or to control it across multiple facilities in near real time, and thereby to hedge against the risk of shortages.

Users, if able to reduce demand or increase supply temporarily at one or more facilities, may enter into agreements, make offers, or accept offers, whereby they give up the right to freely use all of a resource available to them, in exchange for certain consideration. This "negative demand" could be viewed as "positive supply" in a market or trading exchange. Users of any size may wish to trade in their ability to reduce demand or add to supply, whether bilaterally, in a resource market, or in a trading exchange. Other users, lacking the ability to adjust their own resource consumption or production, or placing different values upon doing so, may wish to enter into such trades to hedge their vulnerability to price spikes and/or short-term supply shortages. The difficulty in physically delivering on such trades exactly when required, particularly when multiple facilities are involved, limits the ability for such trading to provide effective hedges against demand and supply volatility.

Once a user has altered his resource consumption or supply, the user may further benefit from certain secondary economic effects, such as pollution allowances or credits. Users would further benefit from the added ability to associate specific changes in power consumption or production with such ancillary instruments and trade in them accordingly.

In light of the spread of terrorism, governmental agencies have an increased need to intervene rapidly and precisely in resource distribution systems in response to attacks on national infrastructure, beyond existing needs of a more regulatory nature. In an interventional mode, governmental agencies have a need for resource control much as suppliers, distributors, and customers do during shortages situations, but governmental agencies also experience the same informational and control limitations.

These and other drawbacks exist with current systems and methods.

### SUMMARY OF THE INVENTION

The invention is defined by independent claims 1 and 14.

Accordingly, various embodiments of the present invention may be directed to a system and a method for remotely monitoring electrical and/or mechanical equipment in which a user, through an embodiment of the present invention and/or through the user's prior instructions, may effect the alteration of the use or operation of a piece of equipment remotely, preferably interactively. In connection with the remote monitoring of various equipment, data may be collected over time concerning the monitored equipment. As the use or operation of a device may be altered remotely, a corresponding resource-consumption and/or resource-production amount may also be remotely controlled and adjusted.

An embodiment of the present invention is directed to remotely adjusting, or causing the remote adjustment, of the use, state, parameters or characteristics of one or more devices, processes, or both, for reducing resource demand and/or adding to the resource supply. The remote adjustment may originate from a user associated with the devices, a supplier or distributor of a resource for operation of the devices, a third party such as a utility industry participant, a government entity, a trader in a resource for the operation of the devices, or any other entity. The adjustment of resource-consumption and resource-production may be based on a user's initiation, a triggered event/condition, a predetermined schedule, or other defined scheme.

According to an exemplary embodiment of the present invention, monitor data messages from devices may be received at a central server. The monitor data messages may include data related to resource utilization, environmental factors, parameters, states, operating characteristics and/or performance data including fault data. Command messages may be transmitted to some or all of the same devices, and/or alternate devices, to adjust demand for and/or supply of a resource. Such adjustment may further be in response to trading activity associated with the resource. Adjustment of resource-consumption and/or resource-production may in turn generate information regarding the devices' altered resource consumption or production to be supplied to a trading network. Resource demand associated with a device may be adjusted by reducing its net consumption, increasing its net production (if any), or performing both.

According to one example, wireless networking, which may be supplemented with other networks, may be used to monitor one or more energy-related assets to provide near real-time utilization and operating data including problem data. Monitor data may be received by one or more users or other entities, such as an asset's owners, servicers, energy transmission and generation companies, regulators, traders, and any other authorized and interested entities, via an on-line interface, under programmed control. The monitor data may be controlled by the authorized users or entities. The monitor data, which may be modified by the system, may also be routed dynamically to at least one predetermined user-defined communication device, based on the incoming monitor data and/or defined profiles. Combined with optional external information, such as real-time market pricing data, current and forecasted surplus and deficit resource capacity, etc., various users may initiate demand-reduction-related and/or supply-increase-related commands via a user interface, which may be accessed over a communication link, such as via the Internet, regarding some or all assets associated with the invention. A central server may send messages to the appropriate one or more assets and/or predetermined communications devices regarding reducing resource demand and/or increasing resource supply. Compliance, audit and/or billing-related data may also be collected automatically by the system. These information flows may be used for adjusting in approximately real-time for the level of compliance with centralized resource demand-reduction and/or supply-increasing directives and/or requests, for dispatching utility and equipment service fleets, and to enable trading in avoided resource consumption and/or surplus capacity.

According to another exemplary embodiment, wired or wireless interface units may be installed at a plurality of user locations, such as numerous large commercial facilities, to monitor the condition, quantity and/or quality of energy sources and loads, and/or to coordinate responses to unusual, out-of-specification, or high-risk equipment states, performance and/or behavior as it occurs. Entities, such as enterprise energy managers and others, may review and manage their locations' energy and asset profiles on line or via other modes of communication. Through the system of an embodiment of the present invention, users may control and/or adjust energy consumption profiles of one or hundreds of facilities or assets simultaneously, utilizing a command broadcasting feature. For example, devices, such as HVAC, refrigeration, lighting, production machinery, electronic controls, and other equipment, may be idled, adjusted, or utilized less frequently or less intensively, or their energy consumption may be reduced for a certain time frame, such as the duration of brownout warnings, price spikes, or just to save money (and energy). As a result, users may respond quickly enough to alerts to practically avert brownouts and rolling blackouts, or to price spikes to maximize the economic or trading benefits.

The cost of a brownout or blackout is substantial, as is the cost of adding generating plants and upgrading transmission facilities to assure adequate capacity in the event of a spike in demand or an unexpected loss of generating or transmission capacity. An embodiment of the present invention enables users to respond to a demand event (e.g., a forecasted or actual shortage, brownout or blackout, or an early warning thereof) to reduce demand and/or increase distributed supply extremely rapidly, across a potentially very large number of facilities and assets, throughout an affected portion of a power grid or other resource distribution network. Further, an embodiment of the present invention may also monitor compliance by customers who are cooperating voluntarily with a resource provider, and preferably the level of demand reduction and/or added supply, to ensure proper financial settlement for each unit of demand (e.g., every kW or kWh of energy) reduced or supply added throughout a defined area or a defined set of entities.

### BRIEF DESCRIPTION OF THE DRAWINGS

FIG. 1 is a schematic of a preferred embodiment of a system according to the invention.
FIG. 2 is a schematic of a preferred embodiment of a link between the monitored equipment and the system according to the invention.
FIGS. 3a-d are schematics of links between an end-user's machine and the system according to the invention.
FIG. 4 is a schematic of a preferred embodiment of the electronic message delivery server according to the invention.
FIG. 5 is a flow chart depicting the operation of the system according to the invention.
FIG. 6 is a schematic of a local RF network linking several pieces of equipment together in accordance with an alternative embodiment of the invention.
FIG. 7 is a ladder logic diagram in accordance with the invention for an exemplary air conditioning unit.
FIG. 8 is a schematic of two types of data transport utilized by the invention.
FIG. 9 is a schematic of two Incoming Message Tables each respectively receiving information from the two data transports of FIG. 8.
FIG. 10 is a logic chart illustrating the functioning of the normalization module of FIG. 4.
FIG. 11 is a schematic of the various data tables of FIG. 10.
FIG. 12 is a schematic of the Device Message Table, Delivery Table, and Device Location Table which are part of the relational data base of FIG. 4.
FIG. 13 is a schematic of various tables which contain some of the information of the user-defined message profiles of the invention.
FIG. 14 is a schematic of various tables which contain information of outgoing messages of the invention.
FIG. 15 is a logic chart illustrating the sending out of messages from the system in accordance with the invention.
FIG. 16 is a schematic of the remote interface unit of FIG. 1.
FIG. 17 is a diagram illustrating an exemplary system for monitoring and controlling remote devices, in accordance with an embodiment of the present invention.
FIG. 18 is a diagram illustrating an exemplary central server for monitoring and controlling remote devices, in accordance with an embodiment of the present invention.
FIG. 19 is a diagram illustrating an exemplary decision module, in accordance with an embodiment of the present invention.
FIG. 20 is a diagram illustrating an exemplary trading module, in accordance with an embodiment of the present invention.
FIG. 21 is an exemplary illustration of a user profile, in accordance with an embodiment of the present invention.
FIG. 22 is a flowchart illustrating an exemplary method for monitoring and controlling remote devices, in accordance with an embodiment of the present invention.
FIG. 23 is a flowchart illustrating an exemplary method for monitoring and controlling remote devices, in accordance with an embodiment of the present invention.
FIG. 24 is an exemplary log associated with monitoring remote devices, in accordance with an embodiment of the present invention.
FIG. 25 is an exemplary system for monitoring and controlling remote devices, in accordance with an embodiment of the present invention.

### DETAILED DESCRIPTION OF EXEMPLARY EMBODIMENT(S)

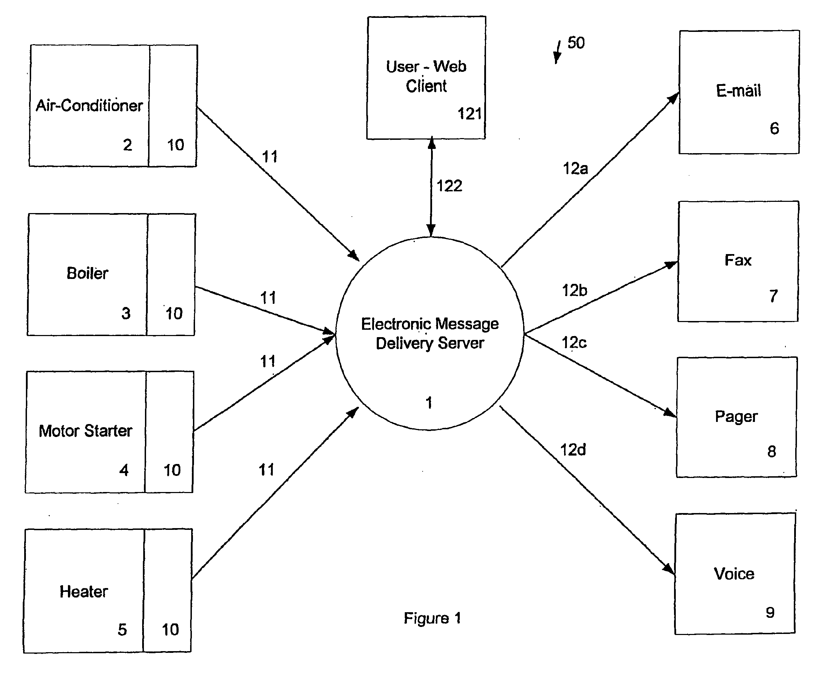

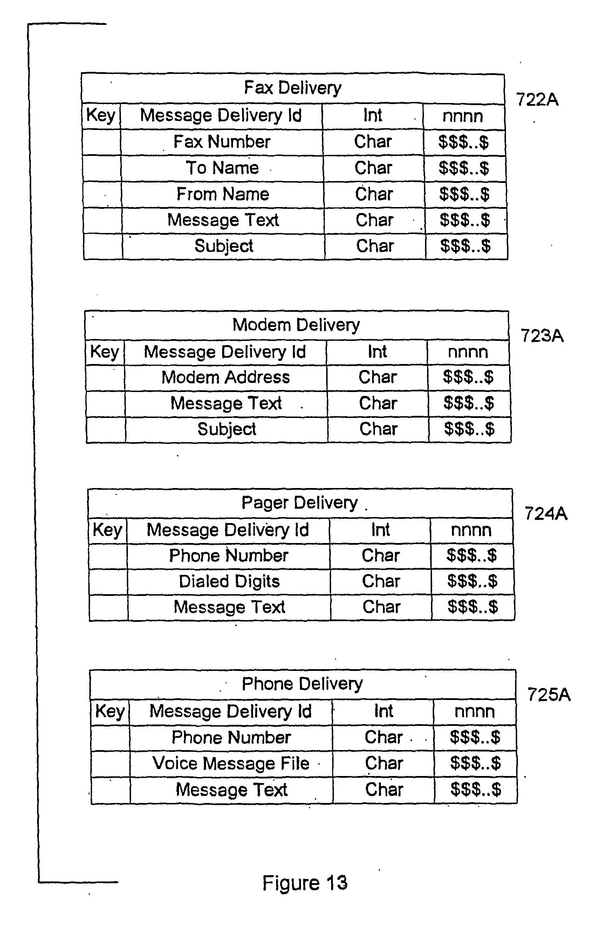

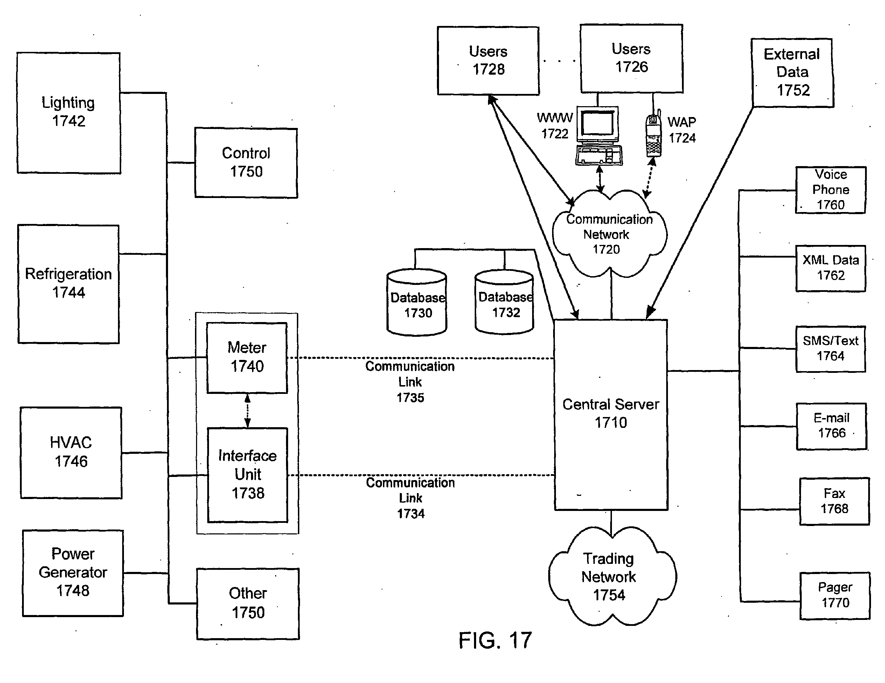

FIGs. 1-16 depict various embodiments of monitoring a plurality of remote devices. These systems may be implemented for purposes of broader application in systems for controlling and adjusting the remote devices, as shown in various exemplary embodiments by FIGs. 17-25.

FIG. 17 is a diagram illustrating an exemplary system for monitoring and controlling remote devices, in accordance with an embodiment of the present invention. One or more devices may be controlled and/or adjusted based on an informational message, which may be initiated by an entity, such as an end-user, suppliers or providers of resources (e.g., power companies, utility companies, etc.), a host system, government entities, public interest groups, traders and/or other entities. The informational message may also be initiated automatically by an embodiment of the present invention. The informational message may include a command or command message, a control signal or other signal that may be automatically generated and/or generated in response to an external input. Further, the informational message may be transmitted to the devices, intended recipients via a preferred mode of communication and/or other recipients. The devices may be remotely adjusted for reducing resource demand and/or adding to resource supply. For example, resource-consumption may be controlled by an entity, such as a utility or power supplier, for reducing demand and/or increasing resource supply for a customer base. In addition, energy may be managed by an end-user (e.g., customer, business owner, etc.) for conserving energy and/or increasing the end-user's internal power supply, which added power may be supplied to the grid (or other resource transmission equipment). The devices to be adjusted, the manner in which they are to be adjusted, when they are to be adjusted (e.g., per trigger conditions or events, schedules, etc.) and other factors may be determined by an embodiment of the present invention.

An embodiment of the present invention provides detailed information concerning the devices, supply sources, relevant external and other data. The detailed information is further centralized and integrated into various embodiments of the present invention. The centralized and detailed information may be used to achieve improved resource optimization and improved alignment of demand and supply. In addition, embodiments of the present invention allow for sequencing and/or prioritizing assets, supply, users, etc. based on the marginal utility of adjusting each; more accurate and granular predictions of supply and demand levels and imbalances; more granular and more rapid control of resource-demanding and resource-supplying assets; more accurate, rapid and effective feedback communications regarding such assets; and more rapid, focused, and intelligently optimized follow-up actions.

Another feature of the present inventions may be directed to a rules aspect, including a pre-negotiated terms and conditions aspect with associated economic criteria and/or incentives, and including a severity aspect. Further, the scope of rules may be wide and flexible including operational, economic, environmental, schedule-based and other rules. The rules may be user-definable and/or programmable, at a variety of levels (e.g., from an individual asset up to system-wide). Another feature may be directed to an improved re-start capability following a blackout or other event having a similar effect, allowing selective restoration of loads and selective control over distributed sources of supply, to avoid over-stressing or interfering with supply/distribution as power comes back online.

Based on user profiles, including incentive and other information, an embodiment of the present inventions may automatically send or route follow-up messages to systems and/or users. Follow-up messages may include a request for additional resource curtailment and/or supplying actions. For example, if a customer has maximally curtailed resource usage (which may be based on the customer's profile) but more curtailment is still needed, an embodiment of the present inventions may send an escalation message indicating that additional curtailment. The escalation message may also include a corresponding price or other incentive which may be considered in potential further curtailment actions. In another example, an embodiment of the present inventions may automatically generate follow-up messages based on knowledge of a user's assets and data indicating that the user has not opted in for their full curtailment potential. In another example, a message may be sent to each asset owner of a certain class who is already maxed out. Many variations and other programmable possibilities may be implemented.

As shown in FIG. 17, a Central Server 1710 may receive commands from one or more users, 1726, 1728, via various modes of communication, including a computer 1722 over a communication network 1720 (e.g., the Internet, private network, internal network, etc.), wireless communication 1724 and others. For example, the central server may also self-generate commands, control signals, informational messages as well as receive computer-generated commands and other messages from an outside system. Users may include end-users, users associated with the devices, suppliers of a resource for operating the devices, third parties, resource-related entities, government entities, public interest groups, traders, and/or any other participants in the system. Central Server 1710 may also maintain one or more databases 1730, 1732 for storing and managing a variety of data, including user profile data, device data, user defined rules, and other types of data.

The Central Server 1710 may include a server for receiving a command message and generating a control signal or informational message in response. In another example, the control signal or informational message may be automatically generated by Central Server 1710. The control signal or informational message may be communicated via a communication link 1734 to an interface unit 1738, such as a gateway, monitoring and control transceiver, or other communications component or device, and/or to other intended recipients using a variety of modes of communication, such as voice phone 1760, XML data 1762, SMS/text messaging 1764, e-mail 1766, fax 1768, and pager 1770 and/or other modes of communication. The modes of and nature of communication, frequency of communication and other rules and/or conditions associated with the transmission of the control signal or informational message may be stored in a user profile, which may be modified by the user or other authorized entity.

The interface unit may be comprised of hardware, software or both. For example, equipment duty cycles, which may be under hardware control, are often coordinated with manufacturing scheduling, which may be under software control, to reduce the peak level of electrical usage spikes. In addition, Central Server 1710 may communicate with meter device 1740 through a communication link 1735. In another example, communication link 1734 and 1735 may be combined as a single link. The communication link may represent a link or channel supporting any form of communication, including wireline, wireless, Global System Mobile (GSM) communication, power lines, or other medium for transmitting and/or receiving signals or messages.

The control signal or informational message may include instructions for monitoring, adjusting, controlling and/or otherwise manipulating the devices. The control signal or informational message may be transmitted once, multiple times until delivery is confirmed, multiple times until a retry algorithm is completed, iteratively, intermittently, or continuously for a fixed or variable duration. The interface unit 1738 may further communicate with the remote devices to monitor, adjust, control and/or manipulate the devices. Interface unit 1738 may be integrated with or into one or more devices, separate from the devices, and/or operate to control a plurality of devices. In addition, while each component is shown as a single component, multiple components may be duplicated for wider applications. For example, a building may include a plurality of interface units 1738 that may each control a plurality of devices.

The devices may include any equipment that may be monitored, controlled, adjusted and/or manipulated. Such devices may include lighting systems 1742; refrigeration systems 1744; HVAC systems 1746; generator 1748 as well as dehumidifiers, production equipment such as manufacturing and process machinery, motors, and compressors; elevators and escalators; computers, and other controllable devices 1750. The devices may be controlled individually as well as collectively and in groups. For example, an individual control 1750 may adjust an associated device or a plurality of devices. The control 1750 may be integrated with the device or separate from the device. Further, the control 1750 may represent a control system, such as a building automation system, energy management systems, process control system, manufacturing information system, or enterprise resource planning/scheduling system, for controlling a plurality of devices.

The devices may include energy-related assets, which may refer to any device that consumes, stores, or produces some type of energy resource as a result of its operation. A resource may refer to any capacity that enables the devices to operate. Examples of resources may include energy, power, natural gas, and others resources. Other examples of resources may include non-energy related resources such as computing capacity and water resources.

Meter device 1740 may be part of Interface Unit 1738 or vice versa. Meter device 1740, such as an energy meter or other component, may be used to measure an amount of consumption or other condition or action, which may then be fed back to the interface unit 1738, or to the Central Server 1710 via a separate communication link 1735, or both. Alternatively or additionally, the meter device 1740 may incorporate an interface unit 1738 within itself, or the meter device 1740 may be incorporated within the interface unit 1710. A single unit or device may incorporate the functions of the interface unit 1710 and the meter device 1740. The meter device 1740 may, for example, capture energy-related readings to determine how much energy was drawn from a utility during an adjustment (e.g., a curtailment) or the quality of energy produced by a device and provided to a utility grid during an adjustment (e.g., activation of distributed power generation equipment). The meter device 1740 may store or transmit information continuously, at predetermined intervals, intermittently, or on an event-driven basis, for billing, power-quality monitoring, and/or other purposes. Interface Unit 1738 may communicate confirmation data and/or meter data and/or other information to Central Server 1710 via the communication link 1734; additionally or alternatively, meter device 1740 may communicate confirmation data and/or interface unit data and/or other information to Central Server 1710 via the communication link 1735. Upstream communications between the interface unit 1738 and/or meter 1740, and the Central Server 1710, may be initiated by the interface unit on an event-driven basis, a scheduled basis, or on a continuously iterative or streaming basis, or by the central server on an event-driven basis, a scheduled basis, or continuously iterative or streaming basis. The communication link 1734 may also contain subcomponents for the purpose of relaying, aggregating, disaggregating, compressing, and decompressing the communications between the interface unit 1738 and/or meter 1740, and the Central Server 1710.

Based on predetermined rules and/or conditions, confirmation of the adjustment of the devices may be distributed to one or more intended recipients via various modes of communications. For example, recipients may receive confirmation or other information via a preferred mode of communication, such as a voice phone 1760, XML data 1762, SMS/Text 1764, e-mail 1766, fax 1768, pager 1770 and/or other types of communication. The modes of communication, frequency of communication and other conditions associated with receiving confirmation of the adjustment may be stored in a user profile, which may be modified by the user or other authorized entity.

According to another embodiment of the present invention, external data 1752 may also be considered in monitoring, controlling, adjusting and/or otherwise manipulating the devices. External data may include any information that may have some affect on the use of the devices. Examples of external data may include consumption/demand of resources, primary and reserve supply of resources, distribution capacity for resources, pricing and market conditions, weather conditions, emergency conditions, information about trigger events/conditions, past or estimated consumption/supply data, forecasted future consumption/supply data and other information.

According to another embodiment of the present invention, a trading network 1754 may be incorporated to enable the users to trade or sell an amount or unit of a resource associated with a past, present, or future adjustment of the devices. Trading exchanges may be provided for buying, selling and/or exchanging spare generation and distribution capacity made available by a demand curtailment, activation or increase of additional sources of supply, or other adjustment.

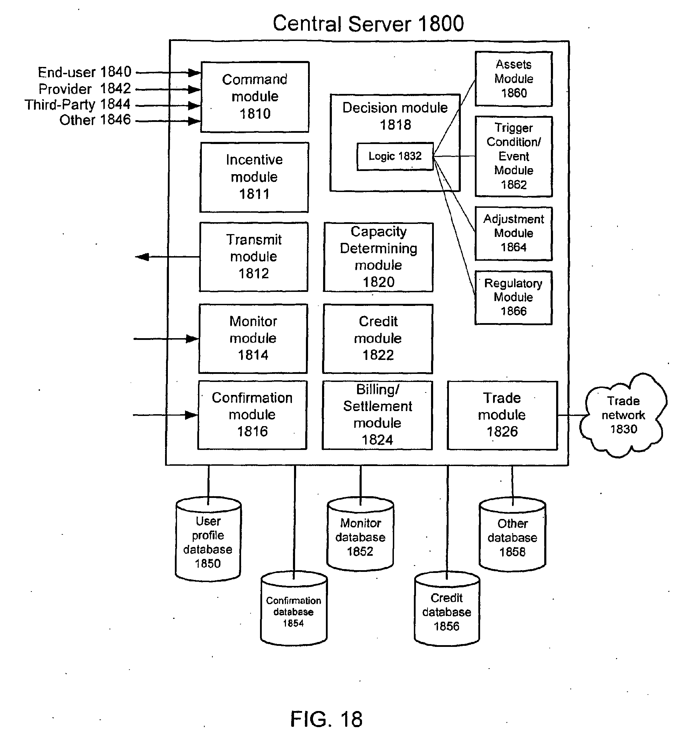

FIG. 18 is a diagram illustrating an exemplary network operating system for monitoring and controlling remote devices, in accordance with an embodiment of the present invention. A Central Server 1800 of an embodiment of the present invention may provide various functions and modules related to monitoring, controlling and/or adjusting remote devices and processing data associated with these functions. The modules of the Central Server 1800 may function separately and/or collectively as well as locally, remotely, and/or in a distributed manner. Further, Central Server 1800 may function as multiple devices or as a single device. Other variations may be implemented.

According to an embodiment of the present invention, Central Server 1800 may provide functionality associated with monitoring, controlling and/or adjusting remote devices for reducing demand for and/or adding to supply of a resource. As shown in FIG. 18, Central Server 1800 may include various modules, such as Command Module 1810, Incentive Module 1811, Transmit Module 1812, Monitor Module 1814, Confirmation Module 1816, Decision Module 1818, Capacity Determining Module 1820, Credit Module 1822, Billing/Settlement Module 1824, Trade Module 1826, and other modules.

The modules of Central Server 1800 may interact with data from a variety of sources, including User Profile Database 1850, Monitor Database 1852, Confirmation Data 1854, Credit Database 1856, and other Database 1858. These databases may function individually and/or collectively where the databases may be accessed remotely and/or locally.

Command Module 1810 may receive one or more command messages from a variety of sources, including an end-user 1840, a provider/supplier of a resource 1842, a third party 1844 and other sources 1846. Command messages may include a command, such as a single push of a button or other action. In addition, the command message may be automatically generated based on predetermined triggers, events and/or other conditions. A command message may include instructions for adjusting characteristics (e.g., state, operation, control parameters, etc.) of the devices. More specifically, the command message may include information related to an amount of adjustment, devices to be adjusted, when the adjustment is to occur, a frequency at which the adjustment(s) may occur, an order of adjustment, how the adjustment is made, and/or other instructions. The command message may be a request, order or a suggestion from an end-user, provider/supplier, third party and/or other entity concerning an adjustment of resource-consumption and/or resource-production.

The command message may be initiated by an end-user 1840. An end-user may be any individual or entity associated with the devices subject to remote adjustment. For example, an owner (or manager, other authorized entity, etc.) of a grocery store chain may desire to reduce power consumption for a time period (e.g., minutes, hours, days, weeks, etc.), which may be scheduled to occur periodically. This may involve adjusting the refrigeration system, dimming the light systems, cycling compressor devices within the air conditioning systems more infrequently, interrupting the use of display case door heating systems, *etc*. The command message may also be generated automatically in response to a predetermined trigger, which may be defined by the user or other authorized entity. For example, the user may define certain conditions under which the devices may be adjusted. Certain conditions may include a sharp change in market price of a resource, a change in weather conditions, etc.

For example, a command message may include instructions to decrease an amount of energy used in operating a lighting system, which may include dimming the light system by a predetermined amount at a remote location. The command message may further instruct the lighting system to operate at a lower level during the daytime when the weather calls for a sunny day. This may be useful for a building or unit with many windows. Further, the command message may instruct the lighting system to increase the intensity during the evening period and during the daytime when the weather is dark and cloudy. Another example may involve adding resources (e.g., power, energy, etc.). In this example, the command message may include instructions to increase the energy supply for a group of devices or a particular building. An increase in supply may refer to activating generators, tapping into other reserve power sources, or other supply of resource.

The command message may be distributed, additionally or alternatively in one or more alternative formats or as part of an informational message, to intended recipients based on a preferred mode(s) of communication, whereby the recipients may initiate appropriate responsive actions.

The command message may also be directed in aggregate to a downstream node which in turn may generate a command signal, informational message and/or control signal to a downstream sub-domain. In reverse, the downstream sub-domain may aggregate feedback data. In this exemplary embodiment, there is a level of distribution of data and/or intelligence as well.

The controlling and monitoring may occur in a tiered configuration for bandwidth conservation and/or distribution of intelligence in a network of devices and central servers. For example, a utility head office (or other entity), which may include a server, signaling module or other module, may send a signal or message to 150 at-risk substations of its 250 substations. The signal or message may be directed to an adjustment in resource-consumption and/or resource-production. For example, the signal or message may include a request to reduce load by 15%. The substations may send appropriate derived signals, perhaps over another type of communication link, to the interface units to make adjustments to reach a goal (e.g., reduction by 15%). The interface units may then effectuate adjustments in resource-consumption and/or resource-production in one or more devices. In addition, reporting may be detailed to the substations and aggregated to the head office. For example, a substation may provide a message to head office where the message may include an substation identification, an adjustment amount and/or other data (e.g., "this is substation 12 reporting 12% impact"). The number of levels of the tiered configuration may be arbitrary.

According to another example, a failover model may be implemented. For example, a head office (e.g., a primary node) may be responsible for controlling and/or monitoring a substation. In the event that the substation is impaired (or experiencing a defect), a backup substation may take over. This exemplary scenario may be pertinent to redundancy of the power grid as well as a terror attack or other event that may impair the control/monitoring capability in any one spot. The failover model may be a series of nodes which may share and/or shunt control/monitoring responsibility among themselves.

According to another example, the command message may be initiated by an entity other than the user, such as a provider 1842 (e.g., a supplier of a resource, etc.) for more efficiently distributed resources. The command message may include a request or an order from provider 1842 to reduce resource consumption by a predetermined amount. The provider may request hundreds, thousands or millions of customers to reduce consumption by a certain amount or percentage. The request may be supplemented by a pricing change or other incentive to encourage greater participation (e.g., more customers), prompt responses (e.g., quicker action) as well as participation at higher levels (e.g., increased curtailment). The requested amount of adjustment may be an estimated amount, projected amount or other amount. One or more of these amounts may be identified by the user or other authorized entity through a user profile.

The command message may also be a request or an order from a provider (or other entity) to select a level of adjustment from a range of levels of adjustment involving reduction in resource consumption and/or increase in resource supply. Each level of adjustment may be associated with a corresponding price or incentive level. For example, in response to a depleting supply of energy and/or a high and increasing demand of energy, a provider may request a plurality of customers to decrease consumption by an estimated amount or percentage by a certain deadline, with possibly higher or greater incentives for a more immediate response. In response to a rise in wholesale resource prices and/or other related prices, a utility company may offer a set of related retail prices or incentives to encourage their customers to scale back use of the resources and/or add to the resource supply.

According to another example, the command message may be initiated by a third party entity 1844, such as a government entity, public interest groups or other entity to improve demand and supply levels. In response to a warning (e.g., of a terrorist attack, brownout, blackout, etc.), some or all users may be forced to reduce or even shut down some or all devices for maximum energy curtailment. For example, in response to a terrorist warning or a terrorist attack, a government entity may issue an order to conserve resources at a maximum level. Other entities 1846 may include traders, the system itself, an outsourced controller and other participants.

External data may be considered in generating the command message. For example, external data may include demand/consumption data, supply data, market assessments, weather conditions, predetermined trigger events/conditions, forecast data, and/or other information affecting a decision, amount, frequency, or other factor associated with adjusting the operation of the devices. These data may be external inputs, or may be obtained or derived through the device-monitoring functionality of the present invention. For example, the system may assess demand/consumption data derived from monitoring data of downstream elements of a power distribution system and associated devices, in view of supply data derived from monitoring data of upstream elements of a power generation and distribution system and associated devices, and determine an optimal mode of operation that may be automatically implemented or approved by the user before implementation.

An entity (e.g., user, provider, third-party, other, etc.) may identify a certain triggering event for adjusting the devices. The event may be any event or condition that initiates an automatic adjustment in operation of the devices. The event may be defined by the user, provider or other entity. For example, a user may define that when a consumption level reaches a predetermined level, a level of curtailment may be implemented which may involve reducing energy consumption throughout the devices. In another example, during periods of the day during the summer season when prices are at peak levels, air-conditioning devices may be adjusted to consume less energy.

The command message may include a request from an entity (e.g., provider, etc.) to reduce resource consumption where a level of curtailment may be calculated for end-users based on an overall target goal of curtailment for a plurality of end-users. For example, an overall goal of curtailment may be an amount or percentage of reduction. Based on the overall goal of curtailment, an appropriate level of curtailment may be determined for each end-user within a group of end-users of the overall system. The end-user may decide how the level of curtailment is distributed throughout the devices. For example, the end-user may determine a level of internal curtailment. Further, the end-user may determine the devices to be adjusted, an estimated amount of curtailment of each of the devices, an order of curtailment for the devices and/or other information. Depending on certain factors, such as an attractive set of incentives, some end-users may be willing to additionally reduce the devices to a minimal operation level. Some end-users may be willing to shut down the devices altogether for the right incentive.

Another example may involve an entity (e.g., end-user, provider, supplier, other entity) requesting an amount or level of curtailment. Based on the curtailment amount or level, an embodiment of the present invention may determine one or more possible ways to reach that curtailment amount or level. For example, an entity may request a curtailment of 15% or submit a more general request, such as "curtail as much as possible" for an emergency mode of operation, "please cut what you can" for a normal mode of operation, or other possibilities. Based on external data as well as pre-defined rules and/or trigger conditions/events, the system may generate an optimal set of curtailment actions or a set of possible ways to reach the desired curtailment. In another example, the entity may specify some or all curtailment actions for reaching the desired level or amount of curtailment.

According to another example, a command message may include an offer from an end-user to effectuate a change in net consumption for a certain amount. The change in net consumption may refer to a reduction in consumption, an increase in supply and/or other adjustment. The offers may be transmitted to one or more entities. The entities may then determine whether to accept or reject the offer. The determination may further involve considering additional data, such as price data, supply data and demand data, in deciding whether to accept the offer before generating a control signal.

According to an example, an end-user may operate devices or the devices may function at a certain level (e.g., level 1) of operation. An entity (e.g., a supplier, a host entity, etc.) may request the user to operate the devices at a different level (e.g., level 2) which may involve a demand reduction (and/or supply increase). The different level (e.g., level 2) may trigger an associated amount of curtailment (and/or new supply). In addition, the different level may also provide the user with a different level of incentive. The different level of incentive may provide a greater economic incentive and/or other additional incentives.

Incentive Module 1811 may generate an appropriate set of incentives for a specific amount or level of curtailment, increase in supply and/or other adjustment. Incentives may include any compensation to the user, such as monetary, discounts, privileges, avoidance of fines or penalties, and pricing mechanisms, for example. Incentives may be fixed, variable or contingent on certain events and/or conditions. In addition, the incentives may be paid up front, in arrears, through bill adjustments or other settlements, and/or other payment arrangements, for an amount of resource reduced and/or an amount of supply added, a potential amount, an estimated amount and/or other amount.

An example may include a spot-bid where an entity (e.g., utility provider, supplier, etc.) may offer a spot incentive based on certain conditions, such as a current severity of power crisis or other critical condition. For the spot incentive, an end-user may accept or select an appropriate level of curtailment (or level of supply to add) or other amount of adjustment. In another variation, the end-users may offer one or more bids to adjust the operation of the devices, which may include reducing consumption and/or adding supply, for a certain incentive (e.g., price, etc.) where the entities (e.g., utility providers) may determine whether to accept or reject the bids.

In response to receiving the command message, the command module may generate a control signal(s) for adjusting the operation of the devices. Transmit Module 1812 may transmit the control signal to an interface unit in communication with the devices. The control signal may adjust the devices as instructed by the command message. The control signal many be broadcast simultaneously to the devices. In another example, the control signal may be transmitted sequentially, according to an order of adjustment defined by the user or other entity.

According to another variation, Transmit Module 1812 may transmit an additional signal with the control signal. The additional signal may be transmitted in parallel with the control signal as well as subsequent or prior to the control signal. For example, the additional signal may include a notification signal that informs other identified entities (e.g., government, public interest groups, etc.) of the intended (or recent) adjustment. The additional signal may include incentive data that may be generated on the fly, which may include tailored incentives based on current market prices and/or other information. The additional signal may also include economic data and other data that may be transmitted to one or more intended recipients.

Monitor Module 1814 may receive monitor data from the remote devices. Monitor data may include one or more performance metrics (e.g., state data, operational data, parameters, characteristics, etc.) associated with the devices. Performance metrics may monitor a level of consumption or production, a state of a device (e.g., an operation mode which may indicate on/off status, *etc*.), an operation temperature (for HVAC devices, etc.) and other characteristics of the device where the performance metrics to be monitored may be defined by the user or other entity. The user or other entity may identify which devices are monitored, what performance metrics are monitored, frequency of monitoring, and other monitor data. The monitor data may be stored in Monitor Database 1852. This data may also be used in forecasting future consumption, supply and/or other actions. In addition, monitor data may also be used in determining whether a demand event/condition has occurred that may trigger an adjustment in the resource-consumption of the devices.

Confirmation Module 1816 may receive confirmation that command messages were received, and may receive confirmation of the adjustments made to the devices in response to the command message. For example, Confirmation Module 1816 may receive confirmation of the curtailment of the devices, an increase in supply of resources, and other action taken in response to the command message. The confirmation may be forwarded to one or more recipients based on a preferred mode(s) of communication. Further, by informing the recipients of the confirmation, the recipients may subsequently access a common site (e.g., a. website) which may contain additional details of the confirmation. Confirmation data may be useful in identifying one or more devices that fail to adjust in accordance with the control signal and/or other non-compliance information. The recipients may be informed of any non-compliance including device specifics, measurements, status, etc. In addition, a report of confirmation, non-compliance and state of the devices may be generated and forwarded to the intended recipients as instructed by the user or other authorized entity. Confirmation data may be stored in database 1854 and may also be used in determining appropriate compensation in an incentive program.

Decision Module 1818 may determine the specifics associated with adjusting the operation of the devices. For example, Decision Module 1818 may determine what devices are adjusted via Assets Module 1860, when the adjustments are performed via Trigger Condition/Event Module 1862 and how the adjustments are made via Adjustment Module 1864, and some or all of the preceding via Regulatory Module 1866, and other specifics. The information generated by the Decision Module 1818 may be used or referenced to generate the command message. Decision Module 1818 may further include logic 1832 for processing data that may be used or referenced in determining the assets, conditions and adjustment for the devices.

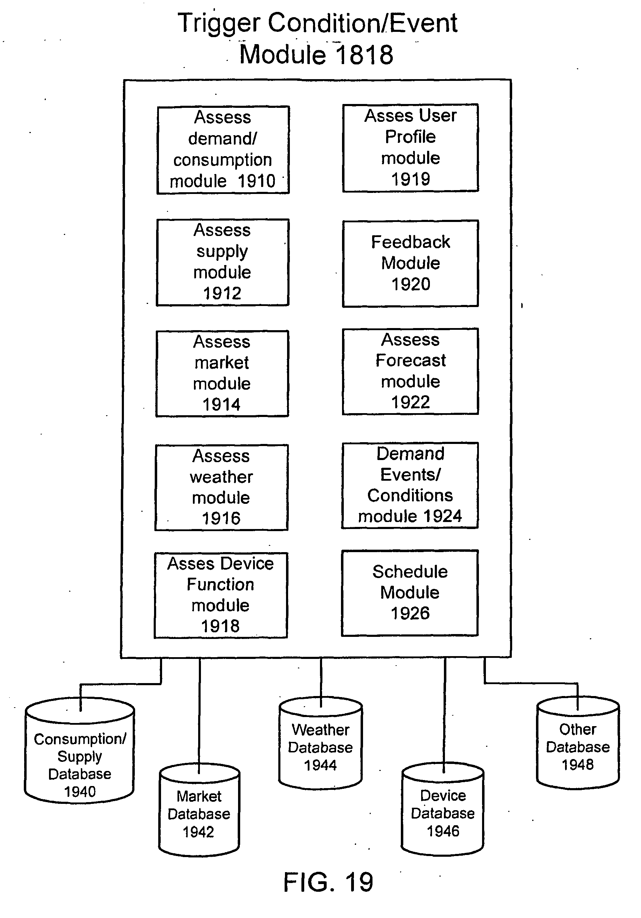

Assets Module 1860 may represent the devices to be adjusted. The devices may be a single device to hundreds or thousands of devices located around the world. Trigger Condition/Event Module 1862 may represent various predetermined triggers for making certain adjustments. Trigger Condition/Event 1862 is discussed in detail in connection with FIG. 19 below. Adjustment Module 1864 may provide information directed to how the devices identified in Assets 1860 are adjusted when a trigger identified in Trigger Condition/Event 1862 occurs.

Devices may be adjusted in a manner that reduces resource demand and/or adds to the resource supply by Adjustment Module 1864. For example, adjustments may include process changes, adjustments to usage or state of the devices, cycling patterns and/or durations, duty cycles, set points, on/off states, operating or control parameters, disconnection from supply, alternate operating modes, interruption of processes or use of devices and other actions. Additional supply may be brought on line (e.g., backup power generation), where such supply may be less than an internal demand or where such supply is greater than an internal demand, such that net supply may be added to a supplier's distribution (e.g., distribution generation). Other control actions may include turn off chillers, use economizers, increase zone temperatures, reduce flow through supply and return fans, increase supply air temperature, increase chilled water temperature, reduce chilled water flow, turn off unnecessary lighting, turn off all non-essential office and other equipment, run back up or emergency generators and other actions.

In another example, Adjustment Module 1864 may balance the operation, state or other characteristic of the devices based at least in part on an assessed consumption amount and/or an assessed supply amount. The consumption amount and the supply amount may be estimated amounts. In addition, the balancing of resources may be performed for the devices of a single user. The devices to be adjusted may be defined by the user or may include all devices associated with the user. In addition, the balancing of resources may be performed for a plurality of users. For a group of users (e.g., parent company, affiliated company, etc.), an amount of consumption may be adjusted throughout the plurality of users, who may be affiliated or not.

Further, Adjustment Module 1864 may adjust the devices according to a priority order where certain devices are adjusted before others. In addition, some devices may be adjusted in multiple ways. For example, an air conditioning system may be adjusted by lowering the temperature, reducing compressor activity, adjusting fan speed, etc. The priority order may be based on an amount of resource-consumption associated with each adjustment mechanism. For example, reducing compressor activity may use less resource-consumption than adjusting fan speed. Other factors may be considered.

Further, Adjustment Module 1864 may adjust devices in general terms which are made specific by one or more of distributed elements of the Central Server 1800, interface units, or the devices themselves. For example, when a building-level control system is used in conjunction with an interface unit, and the control system is capable of implementing multiple energy profile modes within its building, the Adjustment Module 1864 can adjust for a building-level change which is implemented on a device-by-device basis through the execution of predefined programming resident in the control system.

In addition, Regulatory Module 1866 may provide information related to governing laws and/or regulations. Other state or governmental information may also be made available to ensure compliance with current laws, regulations and other mandates.

Capacity Determining Module 1820 may determine a change in resource demand or production associated with the devices resulting from an adjustment. The change may be measured or quantified into a unit of measure. For example, the change may represent capacity saved as a result of a reduction in energy (or other resource) as well as capacity utilization avoided, curtailed or reduced. In another example, the change may represent supply added.

An actual amount of change may be calculated for a specific user(s) for a specific adjustment(s). The amount of change may be stored in credit database 1856. In another example, a user's potential reduction may be estimated in advanced and stored in a user profile at database 1850 and/or other database. An amount of potential amount saved for a given level of curtailment by a specific user may be calculated and stored in credit database 1856. In addition, an amount of potential amount added for a given level of added supply for a specific user may be calculated and stored.

Further, each unit of change within a defined area resulting from the adjustment may represent an amount of compensation to the user. The amount of compensation may be a fixed amount, a rate-based amount or other determined amount. A unit of change in resource demand/supply may be a predetermined number of kilowatts of energy or other measure.

Credit Module 1822 may credit the user for the change in capacity determined by Capacity Determining Module 1822. An amount or indication of credit may be stored in credit database 1856. For example, the user may be credited for an amount of capacity saved. The user may receive a specific dollar amount for each kW of energy curtailed. Other arrangements may be implemented. For example, the users may include end-users, utilities, providers, suppliers, government entities, and/or other third parties. The credit may also be transferred or assigned to another entity. The value of the credit may be more or less depending on certain conditions, such as depleting supply and/or increase in demand. In addition, data may be generated for offering a credit (payment, economic exchange, reward) to a user as an incentive to participate in a curtailment program or other action that involves adjusting the operation of one or more devices. The credit may involve an economic incentive, such as a payment and/or a special rate tariff, and/or other incentive, such as privileges, rights, or other reward. Another type of credit may involve an avoidance of a fine or other penalty for non-compliance. For example, when a user maintains private generators for generating energy which are added to the public supply, the user may be penalized for supplying low-quality electricity to the grid. In this example, the user may be penalized for failing to exclude energy if the energy is "dirty" energy.

Billing/Settlement Module 1824 may provide a settlement action associated with crediting/debiting the user or other entity with the change in demand and/or supply. Based on an agreed method of compensation, a user may receive an appropriate price or incentive amount for an action taken (e.g., reduction in energy consumption, curtailment by a certain deadline, or other). The form of compensation may vary and may include monetary amounts, additional privileges, or other form of incentive. This module may be used to ensure that an incentive amount is correctly determined or calculated and may further ensure that the correct user (or other participant) receives the right compensation. Each user may maintain an account which may be credited, debited and billed by the system. Other settlement arrangements may be implemented.

In addition, a billing analysis may be performed where a model of expected performance may be used to value the change in demand and/or supply (e.g., reduction in resource-consumption) at a particular time or for a market price. According to a variation of this example, an actual amount of change in capacity may be compared with the average expected performance to determine an appropriate amount. Weighted averages may also be used. Other methods for calculating compensation may be implemented. The actual amounts of change may be determined by a meter that measures actual usage of a resource, such as electrical usage. The meter may be programmed to measure, record and/or communicate actual usage at various intervals (*e*.*g*., 15 minutes, 30 minutes, etc.), continuously, as certain values or increments occur, when queried, or in combinations thereof.

Trade Module 1826 may enable an entity to trade and/or sell the change in demand and/or supply with other entities, such as end-users, providers, third-parties, traders and/or the host entity via a Trade Network 1830. The Trade Network may be connected to or remote from the Central Server 1800. A user (or other entity) may have an excess amount of supply capacity or ability to avoid normal consumption or demand that may be offered to one or more potential buyers. The amount of resource adjustment may represent an amount of energy or other resource/commodity. In addition, the user (or other entity) may exchange the excess amount for another form of capacity, another resource, a financial or contractual instrument or obligation, or other form of compensation with another entity.

According to another example, the user (or other entity) may accept a plurality of bids from a plurality of participants for an amount of change in demand or supply of a resource. For example, the user may have an excess amount of supply capacity in the form of surplus energy (e.g., kW). At a desired time, the user may offer the excess amount of energy to a plurality of bidders, which may include other users, the host systems, providers (*e*.*g*., utility companies) and other entities. The bidding may occur for a certain time period where at the end of the time period, the highest (or most desirable) bidder may receive the benefit of the excess amount of energy from the user. Other selling and/or trading arrangements may be implemented.

FIG. 19 is a diagram illustrating an exemplary decision module, in accordance with an embodiment of the present invention. As mentioned above, Trigger Condition/Event 1862 may provide analysis that may be used in determining when to make adjustments to the devices. Trigger Condition/Event 1862 may include a plurality of modules that may function individually and/or collectively. Additional modules may provide other functionality associated with determining certain conditions for adjusting or otherwise manipulating the devices associated with a user.

In this exemplary diagram, Trigger Condition/Event 1862 may include a plurality of modules, including Assess Demand/Consumption Module 1910, Assess Supply Module 1912, Assess Market Module 1914, Assess Weather Module 1916, Assess Device Function Module 1918, Feedback Module 1920; Assess Forecast Module 1922, Events/Conditions Module 1924, Schedule Module 1926 and/or other module.

The modules of Trigger Condition/Event 1862 may interact with data from a variety of sources, including Consumption/Supply Database 1940, Market Database 1942, Weather Database 1944, Device Database 1946, and other Database 1948. These databases may function individually and/or collectively where the databases may be accessed remotely and/or locally.

Assess Demand/Consumption Module 1910 may assess a consumption amount of resources associated with the operation of the devices. The consumption amount may represent an amount for a predetermined area, which may include one or more rooms, zones, floors, buildings, blocks, subdivisions, cities, a defined region, or other area. The consumption amount may additionally or alternatively represents an amount for a predetermined type or class of user and/or type or category of device. The consumption amount may represent an amount for a specific one or more devices. The consumption amount may be measured as a defined unit of measure (e.g., kW, etc.), an indication of level (e.g., low, high, etc.), an estimated amount or other unit. The consumption amount may refer to current consumption, theoretical consumption and/or an average consumption for a predetermined time frame. Consumption data may be stored in Consumption/Supply Database 1940.

Assess Supply Module 1912 may assess a supply amount of the one or more resources where the resources may include energy, power, etc. The supply amount may be monitored for a predetermined time period. The supply amount may further be monitored for a defined area which may include one or more devices, rooms, zones, floors, buildings, blocks, subdivisions, cities, a defined region, or other area. The supply amount may additionally or alternatively represents an amount for a predetermined type or class of supply and/or distribution and/or type or category of device. The supply amount provides an indication of a level or amount of available resources. Supply data may be stored in Consumption/Supply Database 1940.

Based on the assessed demand/consumption amount and/or the assessed supply amount, the operation of one or more resources may be adjusted. For example, the consumption amount of one or more resources may be adjusted via the command message, informational message and/or control signal. In another example, the consumption amount of one or more resources may be adjusted based on the consumption amount approaching or exceeding the supply amount by a predetermined amount. In this example, a user may determine that an appropriate time to curtail consumption may be in response to the demand being within 2% (or other percentage or amount) of the supply. The user may also determine the rate or intensity at which the consumption may be curtailed. The rate or intensity of curtailment may also be increased as the demand approaches or exceeds the supply by higher or lower intervals.

Other defined triggers and/or conditions may be implemented. In an exemplary scenario, a user may find it more practical to curtail consumption before demand exceeds supply. For example, if the demand amount approaches a level of supply by a predetermined amount, the user may initiate curtailment in an effort to maintain a desired supply level.

Assess Market Module 1914 may assess market or other price data of resources associated with the operation of the devices. Based on certain market conditions, the operation of the devices may be adjusted accordingly via the command message, informational message and/or control signal. For example, during peak periods of the day and/or season, certain events may drive prices up or down. In addition, higher demands and/or lower supply of resources may effect the market price of resources. Market data and other related information may be stored in Market Database 1942.

Assess Weather Module 1916 may assess weather condition data that may affect the operation of the devices. Based on certain weather conditions, the operation of the devices may be adjusted accordingly via the command message, informational message and/or control signal. For example, an indication of a severe weather condition may affect the operation of devices. An indication of a severe thunderstorm that may likely shut down power in a target area may be considered in curtailing current consumption in preparation of such a weather event. Weather data affecting consumption and/or supply may be stored in Weather Database 1944.

Assess Device Function Module 1918 may assess device function data associated with the operation of the devices. Based on certain device data, the operation of the devices may be adjusted accordingly via the command message, informational message and/or control signal. Device function data may include cost data in operating a device, cost data of the resources for operating the device, ability to reduce resource-consumption of the device, ability to add to the resources, device priority in relation to other devices, lead time for adjustability, allowable duration for adjustment, and/or supported operating capabilities and modes. Device data may be stored in Device Database 1946. An end-user may apply an order of curtailment based on the priority of the devices and other factors. For example, a user may indicate that if weather conditions reach a certain level, resource-consumption associated with HVAC systems may be reduced where compressors are reduced first and thermostats are lowered if the temperature does not reach a certain level by a defined time period.

Assess User Profile Module 1919 may assess user profile data associated with the devices. Based on user profile data, the operation of the devices may be adjusted accordingly via the command message, informational message and/or control signal. User profile data may include contractual and self-imposed terms, conditions, and obligations; economic constraints; aggregated resource usage and/or generation data; geographic data; and economic data. Such data may be stored in the user profile. For example, if local market prices exceed thresholds in certain locations, and prevalent contract terms allow it, resource consumption may be altered in corresponding facilities only.

Feedback Module 1920 may assess feedback data in response to an adjustment of the devices. Based on the feedback data, the operation of the devices may be re-adjusted. For example, an entity, such as a provider, may observe how the devices respond to a curtailment request with a corresponding incentive level and adjust the incentive level based on the response. If the entity observes a low response, the incentive level may be increased to obtain a higher response to the curtailment request. In another example, the curtailment request may be adjusted to a lower level to elicit more participation. Feedback data may include user level data, aggregate data among a plurality of users, and/or aggregate data independent of users. For example, a power demand spike may cause a part of a power grid to fail which would result in a supply decrease, not necessarily captured in aggregation of user-level demand data.

Assess Forecast Module 1922 may predict or estimate future consumption amounts and/or supply amounts associated with the operation of the devices. Based on certain forecast data (e.g., weather, market, consumption, supply, reserve capacity, etc.), the operation of the devices may be adjusted accordingly via the command message, informational message and/or control signal. For example, performance metrics may be measured for the devices, which may include consumption assessments. Based on historical data including past performance and monitored performance metrics, an estimated future consumption amount may be predicated for the devices. For example, based on previous winter seasons with similar weather conditions (e.g., temperature, snow storms, rain, humidity, etc.), an estimated energy consumption amount for a heating system may be used to formulate a command message, informational message and/or control signal. Other past performance data may be used in estimating consumption amounts for a particular device. The performance metrics may include state data, operating data and/or other characteristics. Assess Forecast Module 1922 may gather information from a variety of sources, including Consumption/Supply Database 1940, Market Database 1942, Weather Database 1944, Device Database 1946 and other sources of information and analysis.

Events/Conditions Module 1924 may determine an event/condition that triggers an adjustment in operation of the devices, including a curtailment of energy and an increase in supply. The event/condition may be defined by an entity, including the end-user, provider, supplier, third-party, the system itself and others. For example, the event/condition may include a market price of a commodity exceeding a threshold, a brownout or blackout warning, security warning, hacker alert, terror alert, grid failure, power outage, power failure, security breach or other events or conditions that may affect power consumption and supply. When a demand event/condition occurs, a command message, informational message and/or control signal may be generated to make an appropriate adjustment in the operation of the devices. Other demand event/conditions may include energy curtailment mandates from an entity, where the mandates may be self-imposed by the user.

Certain events/conditions may involve monitoring the devices associated with the user, the user having a user profile and generating the command message, informational message and/or control signal based at least in part on the trigger events. In this example, monitor data associated with the devices may be used in generating a demand event/conditions. If monitor data indicates that a certain device is operating at a level that exceeds a predetermined threshold, a command message, informational message and/or control signal may be generated in response.

According to another embodiment, a trigger event may include a predetermined trigger event, defined by an end-user or other entity. For example, the trigger event may be based on data related to weather conditions, a warning message of an imminent event forcing power reduction, a security event, a rise or drop price of a resource (or commodity) above a predetermined threshold or other event that may be used to trigger an adjustment in operation of the devices. The trigger event may also be based on economic data including real-time spot market pricing data, current surplus and deficit capacity data, and forecasted surplus and deficit capacity data.

Schedule Module 1926 enables adjustments to occur according to a defined schedule. For example, a user may program adjustments to devices at predetermined intervals throughout a time period, such as a day, week, season, etc. For example, adjustments to devices associated with heating and cooling may be made in the mornings, afternoons, evenings and late evenings. In another example, a user may program curtailment adjustments according to a preferred schedule. Schedule information may be stored in a user profile.

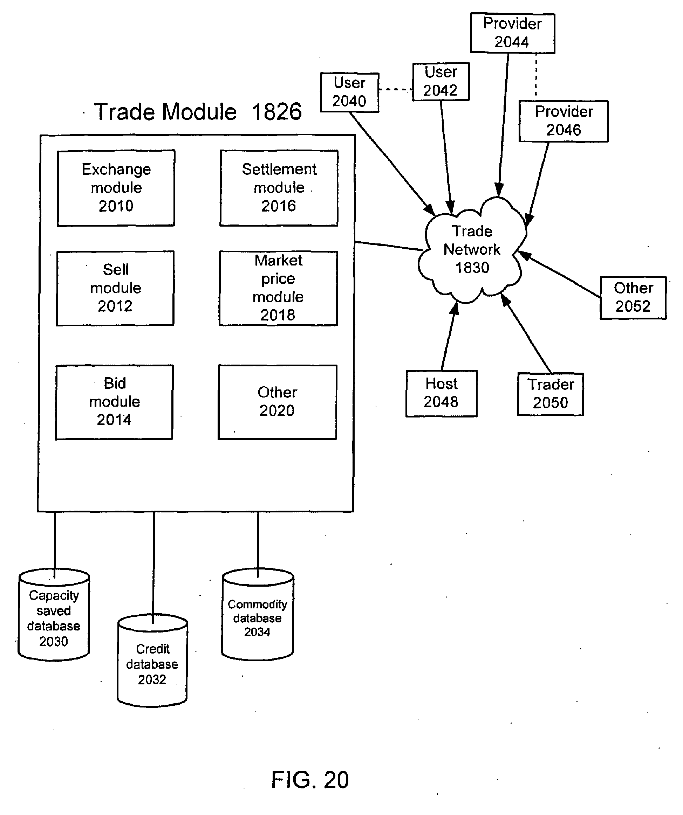

FIG. 20 is a diagram illustrating an exemplary trading module, in accordance with an embodiment of the present invention. A user (or other entity) may trade or sell an amount of change in capacity resulting from an adjustment of the devices via a trade network 1830. Trade Module 1826 may include modules, such as Exchange Module 2010, Sell Module 2012, Bid Module 2014, Settlement Module 2016, Market Price Module 2018 and/or Other Module 2020. Trade Module 1826 may include other modules that provide additional functionality associated with exchanging, trading or selling a change in capacity or other commodity.

The modules may access data stored in Capacity Saved Database 2030, Credit Database 2032, Commodity Database 2034 and/or other databases.

Participants of Trade Network 1830 may include a plurality of users 2040, 2042, a plurality of providers 2044, 2046, the host entity 2048, an trader 2050 and/or other participants 2052.

Exchange Module 2010 enables a participant (e.g., an end-user, supplier, provider, trader, *etc*.) to trade in the ability to deliver a demand reduction and/or supply increase, which may result from an adjustment in the operation of the devices. The trade action may be performed by the participant on an individual basis. In addition, the trade action may be programmed to occur automatically under participant-defined conditions. For example, based on a market price exceeding a threshold, an amount of capacity may be offered for trade for an amount based on the current market price (e.g., $5 below/above the current market price). A participant may offer to trade the excess capacity for another commodity or other incentive. For example, a participant with an excess capacity of energy may trade with a user having an excess capacity of another resource or corresponding instrument (e.g., pollution rights) at an appropriate rate of exchange.

Sell Module 2012 enables a participant to sell an excess capacity for a predetermined monetary amount. For example, an asking price may be based on a current spot market price. For example, the participant may sell any excess capacity at the current spot market price adjusted by a predetermined amount (e.g., market price plus $5).

Bid Module 2014 enables a participant to offer an excess capacity to one or more potential buyers. For example, an end-user may offer an amount of capacity to a plurality of bidders. In another example, the end-user may offer to curtail energy consumption for an amount that a plurality of participants (e.g., providers, suppliers, traders, etc.) may bid on.

Settlement Module 2016 provides settlement functions for crediting/debiting/billing the appropriate entities for the right amount. This module may determine whether each transaction was successfully executed.

Market Price Module 2018 provides market price data that may be used to assist a user, provider or other participant in determining an asking price and/or opening bid. In addition, market price data may be used in triggering a trade, sell or bid action.

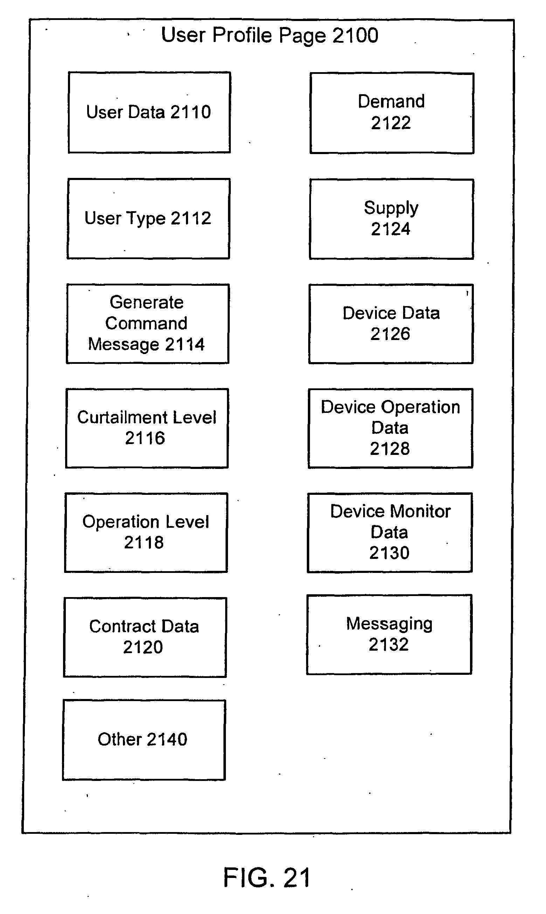

FIG. 21 is an exemplary illustration of a user profile, in accordance with an embodiment of the present invention. Each user (e.g., end-user, provider, supplier, or other entity) of the system of an embodiment of the present invention may create, maintain and modify a user profile. User profile may be accessed by a user through a user interface at a website or other mode of communication. A user may also access user profile information via wireless communications, such as PDA, mobile phone, etc. User Profile page may contain information, such as User Data 2110, User Type 2112, Generate Command Message Interface 2114, Curtailment Level 2116, Operation Level 2118, Contract 2120, Demand 2122, Supply 2124, Device Data 2126, Device Operation Data 2128, Device Monitor Data 2130, Messaging 2132 and Other data 2140. The modules detailed below in connection with User Profile page 2100 may vary for different types of users (e.g., end-user, provider, supplier, third-party, government entity, public interest groups, etc.)

User Data 2110 may contain user information, such as user name, user address, contact information, user agents or affiliates, preferred modes of communication, and/or other data. User data may also include an account which may be used to credit, debit, and/or bill the user.

User Type 2112 may include a user category. This data may be used to operate the associated devices in a particular mode during certain situations. For example, if the user type is a hospital or other emergency entity, certain devices may be operated at normal or operational mode during an emergency crisis. Other user types may include commercial, government, non-profit, health, etc. User types may be further detailed. For health type users, additional categories may include pharmacy, vaccine, hospital, emergency unit, water supply and other. The mode of operation may also involve dictating when the devices are used, how the devices are used and/or other functions.

Generate command message 2114 may include an interface that the user may use to generate a command message. The user may generate command message for adjusting devices. The user may also define conditions under which the devices may be automatically adjusted by the system. In addition, the command message may include a single action, such as a push of button.

Curtailment Level 2116 may include details associated with curtailments levels, including a current curtailment level, previously activated curtailment levels as well as historical data associated with various curtailments levels. For a current curtailment level, the user may view how the devices are operating. The user may also select from a plurality of curtailment levels where each level specifies how each device operates. With this option, the user may curtail each device on an individual basis or curtail a group or all devices at once. In response to a request to curtail energy from a provider, for example, an end-user may easily select a preferred curtailment level. Each curtailment level may be pre-defined by the end-user, provider, supplier or other entity. Further, an end-user may offer to operate in a curtailment mode for an incentive form a provider, supplier or other entity.

Operation Level 2118 may include pre-defined rules concerning operation (e.g., state, characteristics, parameters, etc.) of the one of more devices. For example, an end-user may define rules including multiple operation levels concerning the devices (e.g., normal or abnormal, conservation, economic, emergency, etc.). For example, a user may define certain operation levels that the user may easily activate and quickly switch to. The user defined rules may be generated and/or modified on the fly in response to current information. For example, a user may specify a rule that dictates an operation mode where a reserve spare capacity is maintained at 5%. The user may further define additional rules that may be implemented within the boundary of the rule maintaining 5% spare capacity. Depending on the complexity of the user's systems and situation, multiple levels of rules may be defined where certain rules may be implemented within boundaries of higher level rules. The user may also specify rules regarding how the rules may change (e.g., adapt) to certain conditions and/or events.

In addition, Operation Level 2118 may also include information related to timing related issues, such as a lead time, duration and other data. For example, a user may specify how much time a user may have to respond to a notice, request or order from an entity regarding curtailment or other action. The user may specify a timeout period that indicates participation or no participation if a response is or is not received within a certain time period. Further, a user may specify how long a user or other entity remains in a certain mode of operation.

Contract Data 2120 may contain a contract or other agreement between the user and the host entity concerning a right to control of the devices. In addition, a host entity may reserve a right to overrule any user rights associated with the operation of the devices. For example, in an emergency situation or low power condition, the host entity may overrule the user's right to adjust or operate the devices. Information related to authorized users may also be provided. Certain devices or groups of devices may be allowed or not allowed to operate or function as specified. In addition, rules may be provided as to how certain devices or groups of devices are to operate in response to certain conditions.

Demand 2122 may contain information related to the consumption amounts for devices. Current as well as past consumption amounts may be displayed to the user, via a preferred graphic (e.g., chart, bar graph, or other graphic interface).

Supply 2124 may contain information related to the supply amount for resources. Current as well as past supply amounts may be displayed to the user, via a preferred graphic (e.g., chart, bar graph, or other graphic interface).

Device Data 2126 may contain information related to the devices subject to adjustment (e.g., curtailment). The user may view information related to the location of the devices, via an interactive mapping function; type of devices (e.g., heating system, cooling system, etc.); manufacturer and model; priority order; curtailment order; and other information related to the devices.

According to another example, the devices may include one or more "Smart ID chips" which may participate in identifying each device (e.g., providing an address or other identifier), and identifying its nature, power requirements (or generating capacity), power profile (how much the device draws, and when), ability to be adjusted to various levels of adjustment, current state/parameters, etc. In addition, the ID chips may provide data concerning identity, make, model, serial number, type, category, ownership, location, electronic address, operation, power requirements, resource-consumption, resource-production, power profile, adjustability, current state and/or current parameters associated with the device to a communication device. The ID chips may allow the devices or appliances, individually or in a local network, to respond to a more generalized, goal-oriented control signal (or user-defined goal-oriented response to such a signal) by optimally figuring out how to reduce demand.

Device Operation Data 2128 may provide information related to how each device or group of devices are operating. For example, information directed to the amount of consumption, a rate of consumption, an estimated future consumption for a time period, and other information may be provided.

Device Monitor data 2130 may provide a display of monitor data for the devices. For example, specific measurements, temperatures or other performance metrics may be viewed by the user. Current as well as historical data may be displayed to the user in a preferred graphic, such as chart, bar graph, etc. A monitoring frequency may be analyzed and adjusted as well.

Messaging 2132 may provide rules regarding how one or more recipients may receive certain data via a preferred mode of communication. Modes of communication may include a combination or voice, email, fax, pager, SMS/text, XML data and/or other communication means. For example, a user may specify that certain recipients (who may or may not be associated with the devices) are to receive data by pager depending on the critical nature or another mode of communication such as email for monitor data. In addition, frequency and time of receipt or delivery as well as other characteristics may be specified as well.

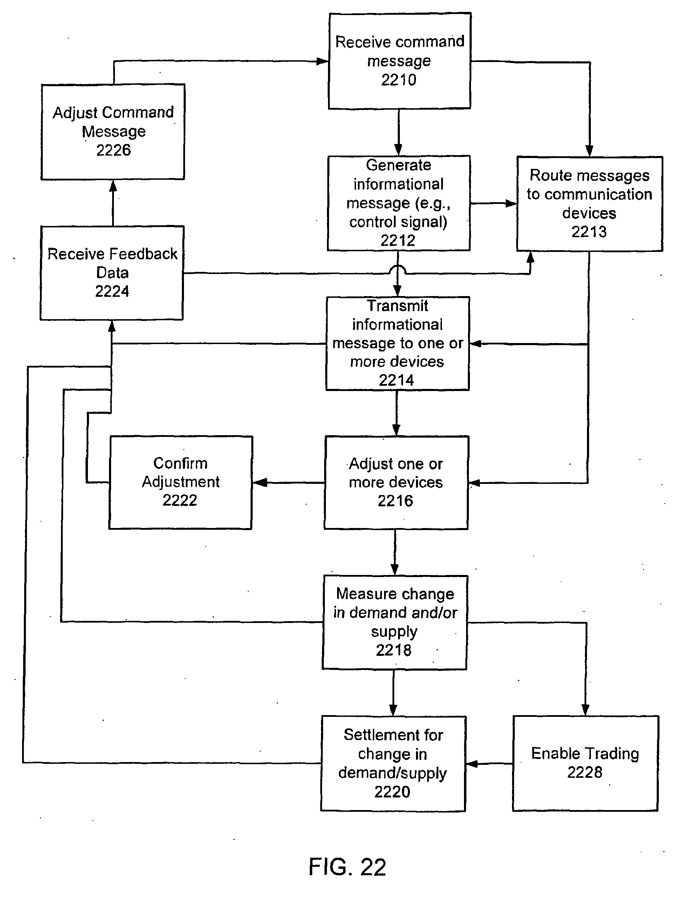

FIG. 22 is a flowchart illustrating an exemplary method for monitoring and controlling remote devices, in accordance with an embodiment of the present invention. FIG. 22 illustrates a method for managing resource-consumption and/or resource-production of devices. At step 2210, a command message may be received at a central server. The command message may be from various users, such as end-user, providers, suppliers, third-parties, government entities, and/or others. The command message may provide an instruction (e.g., order, request, suggestion, etc.) directed to adjusting the resource-consumption of the devices, which may be performed by adjusting the operation of the devices. Identity of the devices to be adjusted, certain triggers or conditions under which the adjustment may occur, instructions directed to a manner in which the devices may be adjusted and/or other information may be provided as well. In an example where a provider (e.g., power company) generates the command message, an incentive may be offered in conjunction with the command message.

At step 2212, an informational message (e.g., control signal, etc.) maybe generated at the central server in response to the command signal where the control signal remotely controls and/or adjusts the resource-consumption of the devices. In another embodiment, the informational message (e.g., control signal, etc.) may be generated automatically where step 2210 may be an optional step. Thus, the informational message may be generated without receipt of a command message. The informational message may reduce the resource-consumption as well as add supply to resources. The informational message (e.g., control signal, etc.) may be transmitted to a remote interface unit, via a communication channel (e.g., wireline, wireless, etc.) to take an action having the effect of providing a change of resource-consumption and/or resource-production attributed to the devices in accordance with the informational message (e.g., control signal, etc.). At step 2213, the informational message (e.g., control signal, etc.) may route messages to communication devices to provide data to one or more intended recipients. For example, the intended recipients may be provided with information regarding an adjustment of resource-consumption and/or resource-production. The intended recipients may then make a determination as to how the one or more devices are to be adjusted, via step 2214 and/or step 2216.

At step 2214, the informational message (e.g., control signal, etc.) from the central server may be transmitted to the devices for adjustment. At step 2216, the devices may be remotely adjusted in accordance with or response to the informational message (e.g., control signal, etc.). At step 2222, the adjustments may be confirmed to intended recipients via a preferred mode of communication. At step 2224, feedback data may be received. Feedback data may be received from the transmission of the informational message (e.g., control signal, etc.), confirmation of adjustment, measurement in change of demand and/or supply and/or settlement for the change. In response to feedback data, the command message (or informational message, control signal, etc.) may be adjusted, at step 2226. In addition, an additional informational message (e.g., control signal, etc.) may be generated in response to the feedback data. Along with the command message, incentive data may also be adjusted in response to feedback data. For example, if only a small percentage of devices responded, the command message may be adjusted to include a greater incentive for resource curtailment.

At step 2218, an amount of change in resource-consumption and/or resource-production resulting from the adjustment may be measured. At step 2220, the user may receive an amount of credit for the change. The credit may be in the form of an economic compensation or other type of compensation. At step 2228, the user or other authorized entity may trade the change in resource-consumption and/or resource-production to potential bidders, buyers, traders and other entities via a trading system, in response to a measured change and/or settlement for the change. Trading may be for a current amount of saved potential as well as for a future intended amount of reduction in resource-consumption and/or an increase in resource-production. In addition, trading may occur prior to receiving the command message where a predetermined trigger condition may invoke a trading action.

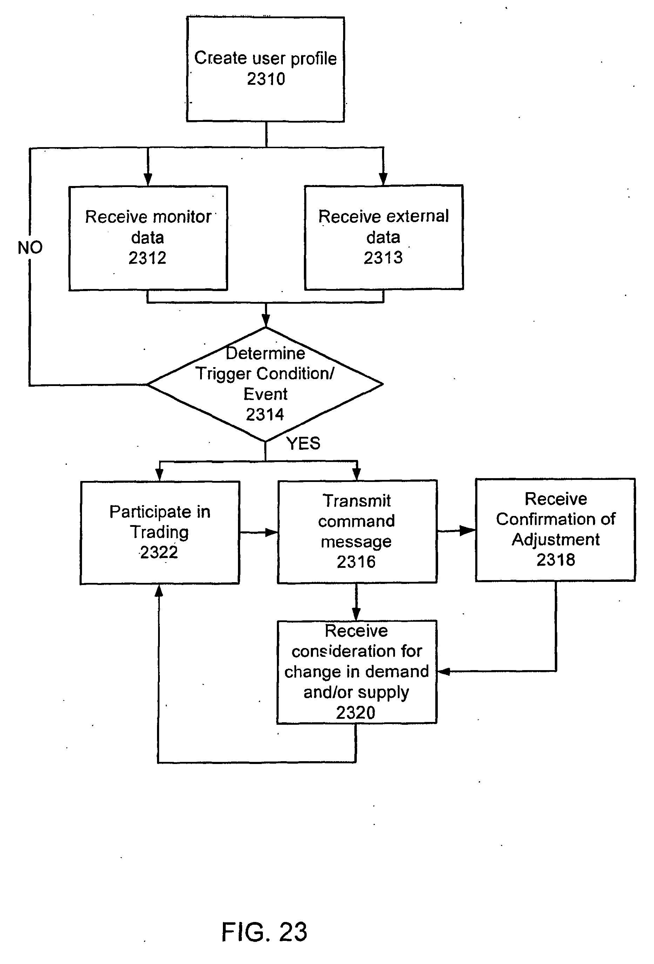

FIG. 23 is a flowchart illustrating an exemplary method for monitoring and controlling remote devices, in accordance with an embodiment of the present invention. FIG. 23 illustrates a method for managing a plurality of devices. At step 2310, a user profile may be created which may include a variety of data, such as a user type, user-defined rules for adjustment (e.g., curtailment, etc.), and other information. The user profile may be created for an end-user, provider, supplier, third-party or other entity. At step 2312, monitor data may be received by the user or other entity concerning the operation of the devices. In addition, monitor data may be received an interface unit where monitor data may include aggregate resource consumption data for an area, such as a region. Monitor data may include various performance metrics, including state, operation and other characteristics. At step 2313, external data may be received from various sources. Whether a trigger condition/event is detected may be determined based on the monitor data and/or other information at step 2314. The trigger condition/event may be a predefined condition or event that triggers the generation of a command message for adjusting the demand and/or adding to the supply or other adjustment action.

If a trigger condition/event is determined, a command message, a control signal and/or an informational message for adjusting devices may be transmitted to a central server or may be generated by the central server, at step 2316. After the devices are adjusted, confirmation of the adjustments may be received at 2318. In addition, non-compliance information may also be received. This data may be used for billing/settlement purposes and for determining an appropriate compensation as well as penalty. At step 2320, consideration (e.g., a credit, compensation, incentive, etc.) for a change in demand and/or supply as a result of the adjustment may be received. In addition, an amount of supply added may be credited to the user. At step 2322, the user may participate in trading and/or selling the amount of capacity saved or supply added with one or more other entities through a trading system.

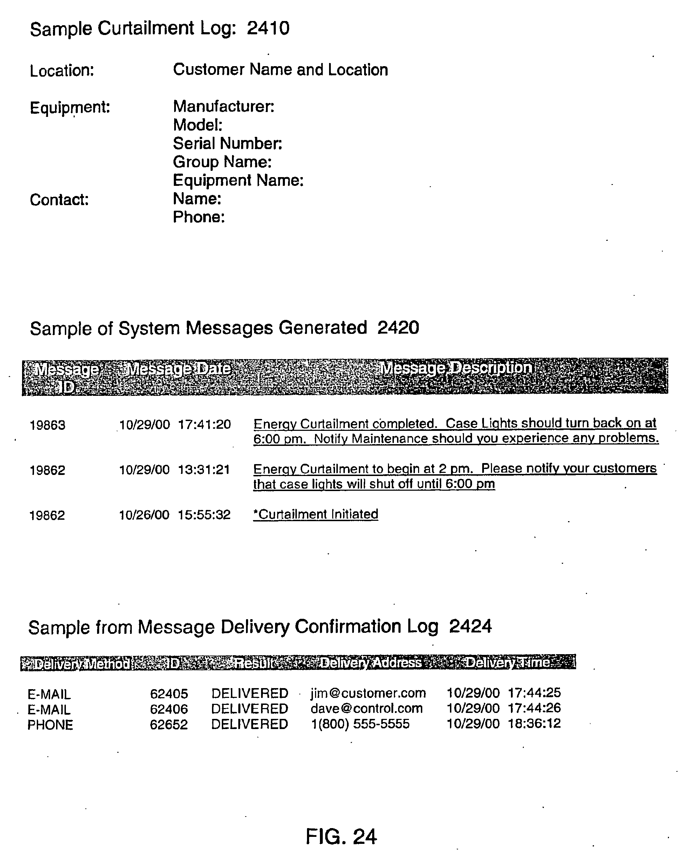

FIG. 24 is an exemplary log associated with monitoring remote devices, in accordance with an embodiment of the present invention. 2410 illustrates a sample curtailment log which identifies an entity and provides details associated with the devices that may be subject to adjustment. 2420 illustrates a sample of system messages generated, including message ID, message date and message description. Sample messages may include confirmation of curtailment action, notification of scheduled curtailment and status data regarding a current curtailment. 2424 illustrates a sample from a message delivery confirmation log, which indicates confirmation delivery, including delivery method, identifier, result, delivery address and delivery time.

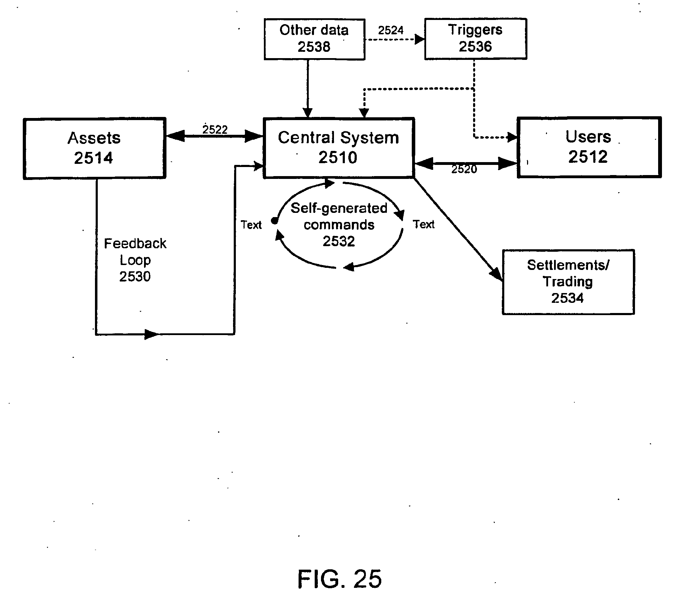

FIG. 25 is an exemplary system for monitoring and controlling remote devices, in accordance with an embodiment of the present invention. FIG. 25 is another illustration of an embodiment of the present invention. As shown in FIG. 25, users 2512 may transmit a command or a command message 2520 to Central System 2510 concerning the control of Assets 2514. Users 2512 may represent an end-user, a user associated with the devices, provider, supplier, third-party, government entity, and other entity. In response to the command message, Central System 2510 may generate a control signal 2522 (or informational message) to control remote Assets 2514. By controlling or adjusting the operation of Assets 2514, a resource-consumption and/or resource-production amount may also be adjusted by Central System 2510. In another example, an informational message may be generated by Central System 2510 and transmitted to Users 2512 where the user may make an determination based on the informational message regarding an adjustment in resource-consumption and/or resource-production concerning Assets 2514.

The adjustment of Assets 2514 may be based on data 2538, which may include external data, consumption amounts, supply amounts, market data, weather data, security events, blackouts, brownouts, etc. Triggers 2536 may also influence the operation of Assets 2514 where triggers 2536 may be pre-defined by various entities, such as end-users, providers, suppliers, and/or others. Triggers 2536 may be pre-defined events and/or conditions which trigger an adjustment in the operation of Assets 2514. As illustrated by 2524, other data 2538 may be used to determine Triggers 2536.

In another example, System 2510 may provide self-generated commands 2532. Certain data and/or triggering events or conditions may provide for an automatic generation of an adjustment in Assets 2514. Commands may also be generated via predefined rules for controlling Assets 2514. For example, if a price of resource reaches a certain level, a predefined adjustment may be performed in response. In addition, a provider/supplier may program an adjustment in response to a supply level reaching a predetermined level.

Based on the adjustment or other action, feedback data may be transmitted from Assets 2514 to System 2510 via loop 2530 where feedback data may reach Users 2512 and/or other intended recipients. Feedback data may be used to generate a follow-up command. In addition, an amount of capacity resulting from adjustments or other actions may be offered to potential buyers or bidders via a Trading Network as shown by 2534.

In accordance with the methods and systems for remotely adjusting remote devices for reducing demand/consumption and/or adding to the resource supply based on user defined data, external data and/or other information relevant in assessing demand, supply and other events/conditions discussed above, it may be appreciated that various iterations and embodiments may be realized.

Methods and systems for controlling one or more of resource-consumption and resource-production associated with a plurality of remote devices may comprise generating at least one informational message at a central server related to one or more of resource-consumption by, resource-production by and control of at least one device; and transmitting the at least one informational message to at least one communication device, where the at least one communication device enables the taking of at least one action having the effect of providing a change of one or more of resource-consumption and resource-production attributed to the at least one device of one or more devices.

The at least one informational message may comprise at least one control signal and wherein the at least one communication device comprises at least one interface unit, where the interface unit in communication with the one or more devices controls the at least one device in accordance with the at least one control signal, to take an action having the effect of providing a change of one or more of resource-consumption and resource-production attributed to the at least one device. Further, at least one command may be received at the central server, wherein the at least one command is related to controlling at least one device and wherein the at least one informational message is generated based on the at least one command. The at least one informational message may comprise one or more of a request to adjust the at least one device, an order to adjust the at least one device, price data associated with the at least one device, change in price data, pricing period data, change in pricing period data, an incentive for an adjustment in the at least one device, a change in incentive, an incentive period, and change in incentive period.

A condition triggering the at least one informational message may be an anticipated future decrease in available energy to the device wherein the condition may comprise one or more of an anticipated future shortfall of available energy; a reduction in reserve or standby resource capacity; an energy-generation outage; an energy transmission outage, an energy distribution outage; and a terror or hacker attack on one or more of resource production, resource supply, resource transmission and resource distribution. The at least one informational message may comprise an instruction directed to one or more of activating and deactivating the at least one device and/or an instruction to adjust the operation of the at least one device wherein the instruction to adjust the operation is directed to one or more of state, use, one or more parameters, one or more set points, operating characteristics, duty cycle, control logic and scheduling of the at least one device. Transmission may occur over one or more of a bi-directional communication link; a cellular telephone network; a radio network, a satellite network, a paging network, a power transmission line; an Ethernet network, a packet network, Internet, a meter-reading network and multiple networks.

In addition, one or more of charges and fees may be associated with the control of the at least one device; a bill associated with the at least one device pertaining to controlling the at least one device may be adjusted. Further, the at least one command may be generated via an Internet interface and in accordance with a user profile. The user profile may be associated with an entity having an interest in one or more of energy consuming devices, energy transmission devices and energy producing devices and may be associated with an entity that generates one or more commands. The interface unit may comprise a plurality of interface units where each interface unit is in communication with at least one remote device wherein the devices may comprise one or more of an air-conditioner, boiler, motor starter and heater and the devices may comprise one or more of a power generator, generator control, automatic transfer switch, fuel cell, photovoltaic cell and wind turbine. The interface unit may cause the adjustments of one or more of resource-consumption and resource-production attributed to the at least one device in accordance with the at least one informational message and the interface unit may comprise an energy metric component.

The at least one command may be generated by one or more of a user associated with the at least one device; a supplier of a resource for operating the at least one device; a distributor of a resource for operating the at least one device; and a third party associated with one or more of supply, distribution and consumption of a resource for operating the at least one device. The at least one informational message may be generated automatically based on external data associated with the one or more of supply, distribution and consumption of a resource for operating the at least one device.

An amount of change of one or more of resource-consumption and resource-production attributed to the at least one device as a result of an adjustment of the at least one device may be determined, wherein the change represents a reduction of resource-consumption and wherein the change represents an increase of supply of a resource capable of being produced by the at least one device. The change may represent a combination of a reduction of resource-consumption and an increase of resource-production of a resource capable of being produced by the at least one device. Data about the amount of change may be collected electronically via one or more of a communication link; a cellular telephone network, a radio network, a satellite network, a paging network, an Ethernet network, a packet network, Internet, a power line and multiple networks. In addition, it may be determined that a current or an anticipated price of a resource is greater than a certain value.

Verification of compliance with information message may include determining that the at least one device has been controlled in accordance with the at least one informational message.

Further, the at least one device may be restored. The methods and systems may restore the at least one device to a state or condition prior to an adjustment made in response to the at least one informational message, wherein the step of restoring further may comprise adjusting one or more of state, use, one or more parameters, one or more set points, operating characteristics, duty cycle, control logic and scheduling of the at least one device. The step of restoring may be performed after a predetermined period of time and/or in response to a trigger event wherein the trigger event comprises one or more of a reduction in shortfall of available energy; an increase in reserve or standby resource capacity; a reduction of end of an energy-generation outage; a reduction or end of an energy distribution outage; and a reduction or end of a terror or hacker attack on one or more of resource production, resource supply and resource distribution. The step of restoring may be performed upon receipt of a restoring command wherein the restoring command is automatically generated based on external data associated with one or more of supply, distribution and consumption of a resource associated with operation of the at least one device.

The methods and systems may further credit the user by adjusting a bill of a user associated with the one or more devices for one or more of activating, de-activating and controlling the at least one device in accordance with the at least one informational message; adjusting a bill associated with the one or more devices for an amount of resource consumption avoided as result of one or more of deactivating and controlling the at least one device; adjusting a bill associated with the one or more devices for an amount of supply added as a result of one or more of activating and controlling the at least one device; generating data for one or more of adjusting a bill and initiating a settlement action associated with the one or more devices for one or more of activating, deactivating and controlling the at least one device in accordance with the at least one informational message; adjusting a bill associated with the one or more devices for an amount of resource consumption avoided as a result of one or more of deactivating and controlling the at least one device; and/or adjusting a bill associated with the one or more devices for an amount of supply added as a result of one or more of activating and controlling the at least one device. In addition, a settlement action may be initiated to ensure an accurate amount is paid to an appropriate recipient from an appropriate payer related to one or more of resource-consumption and resource-production and/or a settlement action may be initiated to ensure a plurality of appropriate amounts is paid to a plurality of appropriate recipients from a plurality of appropriate payers. In addition, a user associated with the at least one device may be compensated based on a difference between a predetermined baseline and an amount attributed to the change in one or more of resource-consumption and resource-production; wherein the step of compensating is performed by crediting the user; wherein the baseline comprises an average amount of change of one or more of resource-consumption and resource-production; and/or wherein the baseline is adjustable based on one or more of time frame, season, and weather data.

A user may accept an offer generated by the central server wherein the offer comprises an incentive for taking an action at or during a certain time; wherein the at least one command comprises an offer from a user associated with the one or more devices to effectuate a change in one or more of consumption and supply of an associated resource for a certain consideration; wherein the change in one or more of consumption and supply comprises one or more of a reduction in consumption and an increase in supply of a resource; wherein the offer is transmitted to one or more entities; and/or wherein at least one of the one or more entities determines whether to accept the offer. In addition, the step of deciding based on one or more of price data, supply data and demand data whether to accept the offer before generating the at least one informational message may be implemented. Further, at least one signal may be generated for terminating the action having the effect of providing the change and transmitted to the at least one interface unit, where the at least one interface unit in communication with the one or more devices controls the at least one device in accordance with the at least one signal, to take an action having the effect of terminating the action having the effect of providing the change. In another example, at least one message may be generated regarding termination of the action having the effect of providing the change; and transmitted to the at least one communication device, where the at least one communication device is associated with at least one entity comprising one or more of a user and an owner of the at least one device. The at least one communication device may include one or more of an email system or device, a pager, a telephone, an SMS or text-messaging device, a mobile computing device, a stationary computing device, a web browser, a server, a software program, a facsimile machine.

According to another example, the at least one informational message may comprise an order to reduce resource-consumption or increase resource-production associated with the at least one device; wherein the at least one command comprises an order to reduce resource-consumption or increase resource-production associated with the at least one device; wherein the resource-consumption comprises energy consumption; wherein the at least one informational message is capable of being overridden by an entity associated with the at least one device; wherein the at least one command is capable of being overridden by an entity associated with the at least one device; and/or wherein the at least one informational message identifies a level of change from a plurality of levels of change wherein each level of change comprises a different level of one or more of resource-consumption and resource-production. Further, one or more of price data, demand data, and supply data may be assessed to determine the order. The at least one informational message may be based on a request from an entity requesting one or more of a reduction in resource-consumption and an increase in resource-production by a predetermined amount, wherein the predetermined amount may comprise an estimated amount based on one or more of demand data, supply data, device data and contract data; and/or wherein the predetermined amount is stored in a user profile. The one or more devices may comprise one or more energy-related assets; the one or more devices are selectively re-adjusted, activated or deactivated subsequent to the one or more device's initial activations, de-activations or adjustments; the one or more devices may be selectively re-adjusted, activated or deactivated by at least one command; the one or more devices may be selectively re-adjusted, activated or deactivated by an additional at least one informational message; and the one or more devices may be selectively re-adjusted, activated or deactivated in response to with a message to a communication device associated with at least one intended recipient.

The at least one informational message may be based on a request from a first entity requesting a second entity to select a level of adjustment from a plurality of levels of response involving the second entity reducing resource-consumption or increasing resource-production. The at least one command may comprise a request from a first entity requesting a second entity to select a level of adjustment from a plurality of levels of response involving the second entity reducing resource-consumption or increasing resource-production, wherein the levels of adjustment comprise one or more of no adjustment and some adjustment; wherein each level of adjustment has a corresponding incentive; wherein the first entity comprises a supplier of a resource for operating the at least one device; wherein the at least one informational message is based on a request from a first entity requesting one or more of a reduction in resource-consumption and an increase in resource-production where a level of adjustment concerning one or more of resource-consumption or resource production is calculated for the second entity based on a user profile; wherein the at least one command comprises a request from a first entity requesting one or more of a reduction in resource-consumption and an increase in resource-production where a level of adjustment concerning one or more of resource-consumption or resource production is calculated for the second entity based on a user profile; where the at least one informational message is based on a request from a first entity requesting one or more of a reduction in resource-consumption and an increase in resource-production where a level of adjustment concerning one or more of resource-consumption or resource production is calculated for the second entity based on an overall target demand or supply goal for a plurality of entities; where the at least one command comprises a request from a first entity requesting one or more of a reduction in resource-consumption and an increase in resource-production where a level of adjustment concerning one or more of resource-consumption or resource production is calculated for the second entity based on an overall target demand or supply goal for a plurality of entities; wherein the second entity decides how the level of adjustment is distributed throughout the one or more devices; wherein the second entity decides the one or more devices to be adjusted and an order of adjustment for the one or more devices; wherein an estimated amount of adjustment of each of the one or more devices is determined; wherein the second entity decides how the level of adjustment is distributed throughout the one or more devices; wherein the second entity decides the one or more devices to be adjusted and an order of adjustment for the one or more devices; wherein the at least one informational message is based on a request from an entity requesting one or more of a reduction in resource-consumption and an increase in resource-production by a predetermined amount for an incentive; wherein the at least one command comprises a request from an entity requesting one or more of a reduction in resource-consumption and an increase in resource-production by a predetermined amount for an incentive; wherein a user associated with the one or more devices determines an amount of one or more of resource-consumption and resource-production in response to the incentive; and/or wherein the resource-consumption comprises energy consumption. In addition, a notification message may be transmitted to the at least one communication device wherein the notification message informs one or more intended recipients of delivery or non-delivery of the at least one informational message and/or a notification message may be transmitted to the at least one communication device wherein the notification message informs one or more intended recipients about the change in one or more of resource consumption and resource production.

An amount of the change in one or more of resource-consumption and resource-production attributed to an entity for a specific adjustment may be calculated and the amount of the change stored in a database; wherein the amount comprises one or more of an actual amount, estimated amount, measured amount, calculated amount, approximated amount, sampled amount, standardized amount, predetermined amount, extrapolated amount and interpolated amount. A potential amount of the change in one or more of resource-consumption and resource-production for a given level of adjustment attributed to an entity may be calculated and the potential amount stored in a database. Each unit of change in one or more of resource-consumption and resource-production within a defined area resulting from the action determines an amount of compensation; wherein the unit of change in one or more of resource-consumption and resource-production is a predetermined number of kilowatts or kilowatt-hours of energy.

A user may trade, buy or sell an amount of one or more of the change of resource-consumption and resource-production via a trading system wherein the change comprises one or more of current change, future change and prior change. A user may accept one or more bids from one or more entities for an amount of change of one or more of the change of resource-consumption and resource-production. A user may offer a projected amount of change of one or more of resource-consumption and resource-production wherein the at least one informational message is generated based on the projected amount; wherein the one or more entities comprise one or more of other users, one or more resource providers, one or more resource transmission entities, one or more resource distribution entities, trading entities, and an entity associated with the central server. In addition, one or more conditions may be defined concerning bid acceptance from one or more entities for an adjustment in one or more of resource-consumption and resource-production.

A consumption amount of one or more resources associated with operation of one or more devices and a supply amount of the one or more resources may be assessed; wherein the consumption amount comprises aggregate consumption data associated with a plurality of devices; wherein the consumption amount comprises one or more of current consumption, theoretical consumption, anticipated consumption, a steady-sate consumption for a predetermined time frame, a peak consumption for a predetermined time frame and an average consumption for a predetermined time frame; wherein the consumption amount is extrapolated from a plurality of devices contributing to aggregate consumption within a predefined area; and/or wherein the plurality of devices comprise a combination of the one or more devices in communication with the at least one communication device and other devices. In addition, one or more of the resource-consumption and resource-production of the one or more devices may be adjusted based on the assessed consumption amount varying from the assessed supply amount by a predetermined amount; wherein the assessed consumption amount comprises aggregate consumption data from a plurality of devices.

Price data associated with one or more resources associated with the operation of the one or more devices may be assessed; wherein the price data is considered in generating the at least one informational message; wherein the price data is compared to at least one predetermined price threshold and/or wherein the at least one predetermined price threshold is stored in a user profile. Further, a plurality of devices may be monitored and a plurality of price data may be determined based at least in part on the step of monitoring data wherein the plurality of price data is considered in generating the at least one informational message; wherein the plurality of devices comprise one or more of resource transmission equipment, resource distribution equipment, the one or more devices and meter devices. In addition, a plurality of devices may be monitored and a plurality of price data may be determined based at least in part on the step of monitoring data wherein the plurality of price data is considered in generating the at least one command. Price data associated with one or more resources associated with the operation of the one or more devices may be assessed; wherein the price data is considered in one or more of activating, deactivating, controlling, and not controlling the at least one device.

Forecast data of one or more of consumption amount and supply amount associated with one or more resources associated with the operation of the one or more devices may be assessed; wherein the assessed forecast data is considered in generating the at least one informational message.

Device function data associated with the operation of the one or more devices may be assessed; wherein the assessed device function data is considered in generating the at least one informational message; wherein the device function data comprises one or more of cost data in operating a device, cost data of one or more resources for operating the device, information regarding an ability to adjust one or more of resource-consumption and resource-production by the at least one device and priority of controlling the devices in relation to other devices.

Weather condition data affecting the operation of the one or more devices may be assessed; wherein the assessed weather condition data is considered in generating the at least one informational message. User profile data associated with the operation of the one or more devices may be assessed; wherein the assessed user profile data is considered in generating the at least one informational message; wherein the user profile data comprises data representing one or more of an average demand and an average supply.

One or more event conditions may be assessed which may comprise one or more of power reduction warnings; national, region or local security warnings; power or energy shortage warning; terrorist attacks; power outages; equipment outages; power system restoration; wherein the assessed one or more event conditions is considered in generating the at least one informational message. One or more energy curtailment mandates from an entity may be identified; wherein the one or more energy curtailment mandates is considered in generating the at least one informational message; wherein the mandates are self-imposed.

The operation of the one or more devices may be balanced based at least in part on one or more of the consumption amount and the assessed supply amount where the step of balancing may occur among one or more entities.

Feedback data may be received in response to transmission of the at least one informational message; and at least one additional informational message may be generated in accordance with the feedback data. Feedback data may be received in response to an adjustment of the at least one device; and operation of one or more devices may be re-adjusted based at least in part on the feedback data. Feedback data may be received in response to an adjustment of the at least one device; at least one message may be generated based on the received feedback data; and the at least one message may be transmitted to the at least one communication device, wherein the at least one communication device is associated with at least one recipient; the step of re-adjusting is performed in response to an additional at least one informational message; wherein the step of re-adjusting comprises one or more or activating, de-activating and controlling the one or more devices; wherein the feedback data comprises one or more of device level data and user level data; wherein the feedback data comprises aggregate data among a plurality of entities; wherein the feedback data comprises aggregate data independent of specific entities; wherein the step of re-adjusting further comprises adjusting an incentive associated with the adjustment of the at least one device; and/or wherein the step of re-adjusting further comprises adjusting a price associated with a resource associated with operation of the at least one device.

At least one performance metric of the one or more devices may be measured; future performance of the one or more devices may be predicted based on the step of measuring; and the at least one informational message may be generated based at least in part on the predicted future performance; wherein the at least one performance metric comprises one or more of state characteristics, parameters and operating characteristics and wherein the future performance comprises one or more of future resource-consumption and future resource-production.

One or more devices associated with a user may be monitored, the user having a user profile identifying the one or more devices; and the at least one informational message may be automatically generated based at least in part on the step of monitoring. At least one trigger condition may be identified for automatically initiating adjustment of one or more of resource-consumption and resource-production of the at least one device, wherein the adjustment is directed to one or more of state, use, parameter, set points, operating characteristics, duty cycle, control logic and schedule associated with the at least one device; and the at least one informational message may be generated in response to an occurrence of the at least one trigger condition; wherein the at least one trigger condition comprises a predetermined trigger condition defined by the user; wherein the at least one trigger condition comprises a predetermined schedule of adjustments in the one or more of resource-consumption and resource-production of the at least one device; wherein the at least one trigger condition comprises a predetermined weather condition where an occurrence of the predetermined weather condition triggers an automatic adjustment in one or more of resource-consumption and resource-production of the at least one device; wherein the at least one trigger condition comprises a warning message of an imminent event forcing power adjustment; wherein the at least one trigger condition comprises a predetermined condition involving one or more of real-time, near real-time, forward and anticipated pricing data; wherein the price data comprises market price data; wherein the at least one trigger condition comprises a predetermined condition involving one or more of time of day, day of week, and season data; wherein the at least one trigger condition comprises a predetermined condition involving current surplus and deficit resource availability data; wherein the at least one trigger condition comprises a predetermined condition involving forecasted surplus and deficit capacity data; and/or wherein the at least one trigger condition comprises a predetermined condition involving a change in price of a resource with respect to a predetermined threshold.

The at least one command may be from a user associated with the at least one device, the user having an associated user profile; wherein the user profile defines in whole or in part an agreement between the user and an entity associated with the central server concerning a right to control of the one or more devices; wherein an entity reserves a right to overrule rights associated with the user in operation of the one or more devices or in response to an event; wherein the user defines or modifies all or in part one or more of the user profile and a profile in which the user has been assigned one or more rights; wherein the user performs the defining or the modifying over the Internet; wherein the user makes available all or part of the user profile in connection with participation in a resource trading network or exchange; and/or wherein the user shares data associated with the user profile with other users.

At least one predetermined rule may be related to controlling the at least one device; wherein the at least one predetermined rule is defined by a user associated with the one or more devices; wherein the at least one predetermined rule is defined at a user interface via the Internet; wherein the at least one predetermined rule is stored in a user profile associated with a user; wherein the at least one predetermined rule comprises one or more situational rules where each situational rule is applicable for an identified circumstance; wherein the at least one predetermined rule comprises a predetermined rule specific for one or more devices; wherein the at least one predetermined rule varies in accordance with feedback data; wherein the at least one predetermined rule varies situationally; wherein the at least one predetermined rule varies dynamically; wherein the at least one informational message is generated in accordance with the at least one predetermined rule; wherein the at least one predetermined rule is directed to controlling one or more of one or more of state, use, one or more parameters, one or more set points, operating characteristics, duty cycle, control logic and scheduling of the one of more devices; wherein the at least one predetermined rule identifies how the one or more devices are monitored; wherein the user defined rules comprise multiple levels of control or adjustment concerning the one or more devices; wherein the at least one informational message initiates one or more actions involving activating and deactivating the at least one device or one or more components associated with the at least one device; wherein the at least one informational message initiates one or more actions involving changing a plurality of set points; changing a plurality of parameters; changing one or more inputs to the at least one device; changing state of the at least one device; reducing an amount of resource supplied to the at least one device over a predefined time period; changing a duty cycle of the at least one device; changing a usage schedule of the at least one device; changing a workload or utilization of the at least one device; changing one or more operating characteristics of the at least one device and changing programming of or software run by the at least one device; and/or wherein the at least one predetermined rule identifies one or more of when and how one or more adjustments to one or more of resource-consumption and resource-production of the at least one device are made. In addition, a user type may be identified and the one or more devices may be operated in a mode based on the user type during a predetermined event.

Confirmation of the action taken may be received and one or more recipients may be informed of the confirmed action taken; wherein the step of informing comprises generating at least one message based on the confirmation; and transmitting the at least one message to the at least one communication device, wherein the at least one communication device is associated with at least one intended recipient. One or more devices that fail to take an action in accordance with the at least one informational message may be identified and one or more recipients may be informed of the identified one or more devices; further at least one message may be generated based on the step of identifying and the at least one message may be transmitted to the at least one communication device, wherein the at least one communication device is associated with at least one intended recipient.

Methods and systems for managing one or more of resource-consumption and resource-production of a plurality of devices comprising making a determination concerning one or more of resource-consumption and resource-production of one or more devices; and transmitting at least one command to a central server, wherein the at least one command is related to controlling at least one device and is based at least in part on the determination and wherein the central server generates at least one control signal based on the at least one command for controlling the at least one device and transmits the at least one control signal to an interface unit to take an action having an effect of providing a change of one or more of resource-consumption and resource-production attributed to the at least one device. Data associated with one or more of resource-consumption and resource-production of the one or more devices may be received, wherein the received data is considered in generating the at least one control signal; and data associated with one or more of resource-consumption and resource-production of the one or more devices may be received, wherein the received data is considered in generating the at least one command. A user profile for monitoring one or more devices may be created wherein the user profile comprises at least one predetermined rule for adjusting one or more of resource-consumption and resource-production of the at least one device and wherein the at least one control signal is automatically generated in accordance with the at least one predetermined rule; wherein the user profile comprises a model providing data describing functionality attributed to the one or more devices; and/or wherein the data comprises one or more of individual device data, aggregate data, resource-consumption data and resource-production data. A message indicating a credit for an amount of the change of one or more of resource-consumption and resource-production of the at least one device may be received. A message indicating a confirmation of the action taken in accordance with the at least one control signal may be received. An amount of the change of one or more of resource-consumption and resource-production attributed to the at least one device may be offered to one or more entities; wherein receiving data further comprises receiving external data affecting an operation of the at least one device wherein the external data is used to define a trigger condition for automatically generating the at least one command for adjusting the resource-consumption of the at least one device. Price data of a resource associated with an operation of the at least one device may be monitored; whether to offer a reduction in resource-consumption based on one or more of price data and forecast data may be determined; and/or an offer to reduce resource-consumption for a predetermined amount may be initiated; wherein the offer is initiated when a market price for a resource exceeds a predetermined level; wherein the offer is initiated when a rate period for a resource changes; wherein the user profile is created at the central server; and/or wherein data comprises aggregate resource consumption data for a predetermined area.

Methods and systems for managing one or more of resource-consumption and resource-production of a plurality of devices may comprise receiving at least one control signal at one or more interface units wherein the at least one control signal is related to controlling at least one device; and communicating with the at least one device in accordance with the at least one control signal, to take an action having the effect of providing a change of one or more of resource-consumption and resource-production attributed to the at least one device. Confirmation of receipt of the communication to a central server may be reported; wherein the confirmation is communicated to at least one communication device associated with one or more intended recipients via a preferred mode of communication. Confirmation of the action to a central server may be reported; wherein the confirmation is communicated to at least one communication device associated with one or more intended recipients via a preferred mode of communication; wherein data comprising one or more of resource-consumption, resource-production, device performance, device parameters, device state, device usage, exception conditions, change in resource consumption or production are measured, individually or collectively; and/or wherein the measured data is communicated to one or more intended recipients via a preferred mode of communication.

Methods and systems for managing one or more of resource-consumption and resource-production of a plurality of devices may comprise receiving at least one control signal at one or more interface units wherein the at least one control signal is related to controlling at least one device; and performing one or more of displaying data and activating, de-activating, and altering one or more of an indicator and an alarm in response to the at least one control signal, to provide information associated with taking an action having the effect of providing a change of one or more of resource-consumption and resource-production attributed to the at least one device; wherein the data comprises one or more of resource-consumption, resource-production, device performance, device parameters, and change in resource consumption or production.

The at least one device may comprise an identifier component for identifying one or more of identity, make, model, serial number, type, category, ownership, location, electronic address, operation, power requirements, resource-consumption, resource-production, power profile, adjustability, current state, current parameters associated with the at least one device to the at least one communication device. The power profile comprises one or more of an amount of power being drawn and when the amount of power is being drawn and the adjustability refers to an ability to adjust to a plurality of levels of adjustment.

Method and systems for controlling one or more of resource-consumption and resource-production associated with a plurality of remote devices may include identifying at least one station from a plurality of stations for adjusting one or more of resource-consumption and resource-production associated with the at least one station; generating a message related to one or more of resource-consumption and resource-production for the at least one station; and transmitting the message to the at least one station wherein the at least one station generates an informational message to at least one communication device where the at least one communication device enables the taking of at least one action having the effect of providing a change of one or more of resource-consumption and resource-production attributed to at least one device associated with the at least one communication device. The message may comprises a command comprising one or more of a decrease in resource-consumption and an increase in resource-production. The at least one communication device may provide confirmation data to the at least one station in response to the taking of the at least one action; wherein confirmation data may comprise data related to one or more of compliance, non-compliance and measure of compliance; wherein the at least one station may gather aggregate data concerning the change of one or more of resource-consumption and resource-production from a plurality of communication devices; wherein the at least one station may operate in a failure mode in response to a condition wherein the condition affects operation of the at least one station; wherein at least one backup station operates on behalf of the at least one station and/or wherein the at least one backup station may comprise a plurality of backup stations where each one of the plurality of backup stations rotate responsibility for the at least one station in failure mode.

As discussed above, FIGs. 1-16 depict an operating environment that may be used for bidirectional communication between a central system and a remote energy consuming device. In these systems, communication for purposes of preventing failure is described in addition to controlling devices for energy management. Each of the systems and methods of FIGs. 1-16 will now be described.

Equipment that needs to be monitored frequently, such as HVAC equipment, preferably operates within certain acceptable parameters. Some of these parameters are more crucial to the operation and/or life span of the equipment than are other parameters. For example, a low battery condition might be a lot less serious than a low coolant level condition. Whenever a piece of equipment operates outside its preferred parameters, an "exception" condition is created or said to exist. An exception condition can also be indicative of a regularly scheduled event occurring too often, too infrequently, or not at all. An exception condition could also be indicative of a measured value being beyond the design specification for the equipment.

When a monitored piece of equipment detects an exception condition, it activates its interface to the cellular phone network. The interface effectively acts as a cell phone in a roaming condition. The interface "attempts" to make a telephone call; because it is not recognized as being a resident of the local cell, the local cell (via the cellular network or mobile switching center) contacts the "home cell" of the interface to insure that the interface is in good standing to complete the "call". There really is no home cell; in actuality, what is taking the place of the home cell of a cellular telephone is a message routing service or data transport such as those provided by Aeris or Bell South Cellemetry. When the local cell is contacting the message routing service, it transmits the following information: the serial number of the interface; the multi-digit "phone number" assigned to the interface; and the multi-digit phone number that the interface is "attempting to call". The message routing service tells the local cell that the interface is okay and should not be blacklisted, that the call need not go through, and that the interface should be removed from the "okay to roam" list immediately.

The interface is not really trying to call anyone; the multi-digit phone number it was trying to call represents a multi-digit code of information that is being sent to the message routing service and may represent fault information (e.g., 212-555-1212 means "filter needs cleaning"). The phone number assigned to the interface (which is also sent along with the phone number it is "trying to contact") may not only indicates which unit is doing the transmitting but may also convey fault information, since many of the devices being monitored do not have a large number of different fault conditions. This type of technology, in which information is transmitted in the handshaking portion of a cellular transmitter communicating to a local cell, appears in U.S. Pat. No. 5,594,740 to LaDue and U.S. Pat. No. 5,546,444 to Roach, Jr. et al., and is commonly referred to as using control channel data. In LaDue (the Aeris version), the exception or status information is embedded in the digits of the "phone number" the interface is allegedly calling (the "dialed digits"); in Roach, Jr. (the Bell South Cellemetry version), the exception or status information is embedded in the electronic serial number (ESN) of the interface, a number which identifies the physical hardware of the device. The information which identifies which interface has sent a message may be embedded in the mobile identification number (MIN) assigned to the interface unit. In the Aeris system, the ESN may also contain interface identification information. The structure of the quanta or packets of information transmitted by typical data transports will be discussed in greater detail below.

The present invention expands on this technology and includes the message delivery technique mentioned above. The Aeris or Bell South Cellemetry router transmits the exception Who data to the inventive message delivery system which forwards the information to the contractor who is responsible for maintaining the faulty equipment. The contractor is provided with an account on the message delivery system that he can access via the Internet. The contractor sets up the specific parameters of which exception conditions are reported to which individuals. The contractor also sets up by which media (fax, e-mail, PCS) these individuals are to be notified. Multiple individuals may be alerted as to a exception condition. All of this data constitutes the contractor's message profile. For example, both the contractor and the owner of the premises might be signaled if there is a low/high refrigerant condition, however perhaps only one of them would be notified if a filter required cleaning. The user may also set, as part of the message profile, that different messages be delivered to different individuals at different times of the day, week, month, season, or year. For example, a high priority exception message may be directed to one repair/maintenance entity during regular business hours but be directed to a different repair/maintenance entity at night. Similarly, the same person could be contacted by different means (e.g., fax or PCS) at different times. The content of the messages may also vary as a function of time. In the present invention, the various aspects of a user's message profile are stored in a plurality of look-up tables on a data base, as will be explained below.

In addition to notifying contractors when a problem arises, the interface may be programmed to check in once a day with an "all systems okay" message. This "okay" message also gets routed to the message delivery system. However, instead of being handled by an exception message subroutine in the message delivery system -the portion of the system which handles the above-mentioned fault messages-, the "okay" message is checked by a missing message subroutine. The missing message subroutine checks the entire list of HVAC interfaces that are supposed to signal "okay" from the message delivery system database. The missing message subroutine compares the entire list to the list of HVAC interfaces that actually checked in as "okay". If an interface failed to check in "okay", the message delivery system sends out the appropriate messages to the proper individuals via the selected media, all in accordance with the user's message profile lodged in the user's account with the message delivery system. The periodic "okay" or status message is not merely limited to providing a status "heartbeat" for the equipment but may also be employed to transmit information about the monitored piece of equipment. As will be explained below, the status message only requires a portion of its digits to convey equipment identification information, thus allowing other information to be transmitted as well. For example, the status message may include statistical information about the equipment such as how many cycles it has performed since the last message, the run time of the motor, etc. The status message may also serve as a reminder for routine maintenance, or it may report very minor or low-priority conditions that are not time sensitive.

The format of the message sent from the failing device to the local cell to the router to the message delivery system is a multi-digit code. The first digit can be for message format (e.g., status message, exception message, etc.). The sub-address is a digit or two reserved to identify to which unit that a transceiver interface is assigned is experiencing an exception condition; i.e., one transceiver interface may be assigned to a building having nine HVAC units, all connected to the transceiver via a bus line, or one interface may be part of a local RF network where each of multiple HVAC units has its own transmitter. The final digits would indicate the specific exception condition.

Because different sites employ different data transports, incoming messages from different locations may have different structures or formats. Also, one would want the inventive system to be able to accommodate additional formats of transports as they are developed without having to rebuild the server every time. It is thus desirable to convert all of the incoming messages into a single normalized format for ease of subsequent manipulation. The multi-digit message received by the message delivery system is normalized, converted into a regular text message, and forwarded to the user/contractor. Information can also include model, brand, installation date, and climate and weather data for the site. Alternatively, much of this type of equipment criteria can be stored at the central data base so that only the equipment identification information need be transmitted.

A number of pieces of equipment may be linked to a single cellular interface via a local RF network. This is advantageous because many buildings have multiple pieces of HVAC equipment, and the provision of each piece with its own cellular interface is expensive. The deployment of a local RF network is also advantageous when the multiple HVAC units are fairly remote and a hardwired connection to a common bus line would be impractical or impossible.

Description will now be given of the preferred embodiments with reference to FIGS. 1-15. FIG. 1 shows an overall view of the inventive system 50. An existing piece of equipment may be monitored, for example; an air-conditioner 2, boiler 3, motor starter 4, heater 5, or any other piece of equipment they may be desired to be monitored. The existing piece of equipment is fitted with an interface unit 10. Periodically, the interface unit 10 sends to the message delivery server 1 a status signal to let the message delivery server 1 know that the equipment being monitored and the interface unit 10 are functioning correctly. When a predetermined exception condition occurs in the piece of equipment being monitored, the interface unit 10 sends an incoming exception message to the message delivery server 1. The message delivery server 1 then routes the message as an outgoing exception message to the appropriate user interface; e-mail 6, fax 7, pager 8, voice 9, etc., according to the message profile as configured by the user of the system 21 via the Internet 122.

The inventive system can be deployed on existing pieces of remote equipment. Various sensors can be added to an air conditioner, a boiler, etc. that can detect various conditions. For example, in an air conditioner, different sensors can be provided throughout the system each to detect a different condition such as low or high pressure, a condensate spill, air flow, fan motion, compressor function, etc. Any and all conventional sensors are contemplated as being usable in the invention, including but not limited to pressure sensors, pitot tubes, motion sensors, photosensors, electrical resistance sensors, moisture sensors, magnetic sensors, and the like.

Whether the sensors are built into the HVAC unit or added later, the various sensors in a monitored piece of equipment are preferably arranged in ladder logic configurations in programmable logic controllers (PLCs). Each sensor is responsible for detecting a certain condition or monitoring a certain parameter. These sensors can be grouped via Boolean logic operators (AND, OR, XOR, NOT, etc.) to provide the circumstances under which an exception condition is defined.

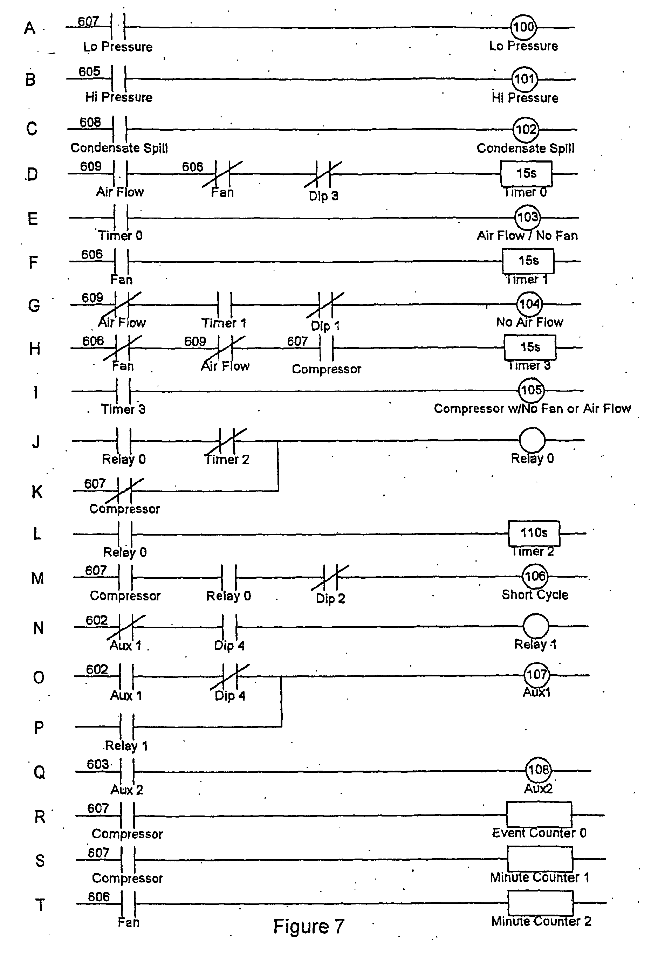

An example of such a ladder logic PLC for a typical air conditioning unit is shown in FIG. 7. Each of sensors 602-609 monitors a different condition/parameter of the unit. Sensor 604 detects low pressure in the coolant, sensor 605 detects high pressure in the coolant, sensor 606 detects if the fan is working, sensor 607 detects if the compressor is working, sensor 608 determines if a condensate spill has occurred, and sensor 609 detects if the compressor is working. Some of the logic is direct and simple. For example, if sensor 605 detects a high pressure condition, high pressure message 101 is sent via the message generating mechanism of interface unit 10. Similarly, if sensor 608 detects a condensate spill, message 102 is sent.

Other rungs of the ladder are more complex. For example, in line F, if sensor 606 detects that the fan is working, timer 1 is activated; if no air flow is detected by sensor 609 before timer 1 times out, the "no air flow" message 104 is sent. If, in line H, sensor 606 detects no fan operation and sensor 609 detects no air flow but sensor 607 detects proper compressor function, and timer 3 times out, "compressor w/ no fan or air flow" message 105 is sent (line I). As another example, message 107 is sent out if sensor 602 detects a logic 0 in "aux 1" input and dip switch 4 is closed (logic 1) by activating relay 1 in line P. Alternatively, if sensor 602 detects a logic 1 in "aux 1" and dip switch 4 is open (logic 0), a message will be sent. In either case, a message 107 is sent in line O.

The dip switches are provided to allow certain portions of the logic to be disabled if a customer is not interested in receiving a certain type of message. For example, a sensor could be set to detect if a compressor is cycling fast and to send a "fast cycle" message in that event. However, if the user has the compressor deliberately set up to cycle fast, the user will not want to receive a constant stream of messages informing him that the compressor is cycling fast. Instead, a dip switch can be set to disable that message from being sent. The conventional dip switch is adjustable on-site. The invention contemplates also enabling the user to set up virtual dip switches via the Internet at a central server as will be explained below.

Each PLC can be different for each unit, type of unit, brand, model, etc. The PLC may be hard wired at the remote installation site in the interface unit. 1 0, or software in the interface unit may simulate the workings of a PLC as a "virtual PLC". Alternatively, the various sensors can be linked via computer software at a web site that interacts with system 21, or a virtual PLC may be provided on server 1. For example, instead of sending out a low pressure message 100 for a low pressure condition and a high pressure message 101 for a high pressure condition, a user can OR the outputs of sensors 604 and 605 together for the sending out of an "abnormal pressure" message. A user can adjust a logic ladder in the same or similar fashion as one would edit a message profile, e.g., by menu-driven websites, by an automated telephone response system, etc. The user can, of course, request an initial hardwired configuration of the system installer and have that adjusted on-site as needed.

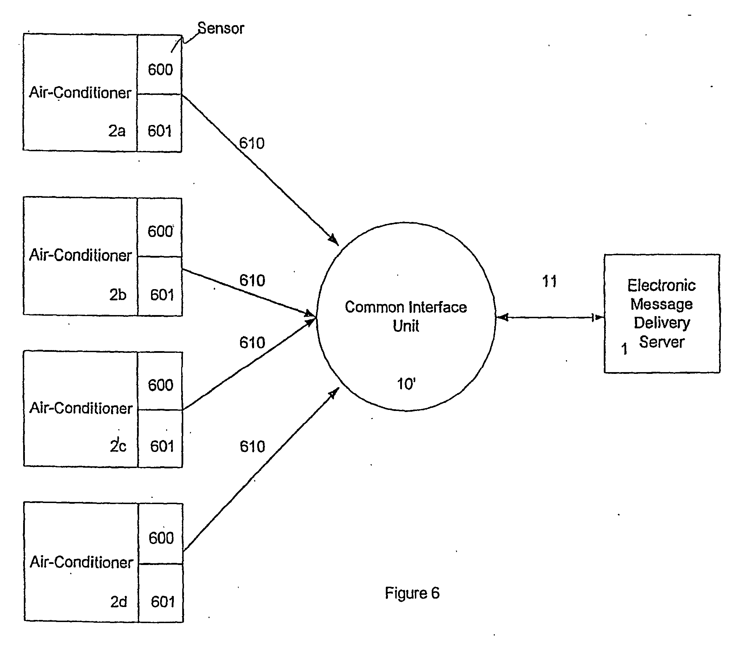

In FIG. 1, each piece of equipment 1-4 is provided with its own interface unit 10. An alternative configuration is shown in FIG. 6. As shown in FIG. 6, four air conditioners 2A-D are each provided with sensor 600 (which generically represents any of sensors 602-609 and any like sensors) and an RF transmitter 601. When an exception condition is detected by sensor 600, or if after a certain period of time, no exception condition is detected, transmitter 601 transmits an RF signal 610 to a common interface unit 10'. Common interface unit 10' includes antenna A for receiving signals 610. Unit 10' sends incoming messages to the electronic message delivery server 1 via link 11 in the same manner as shown in FIG. 1.

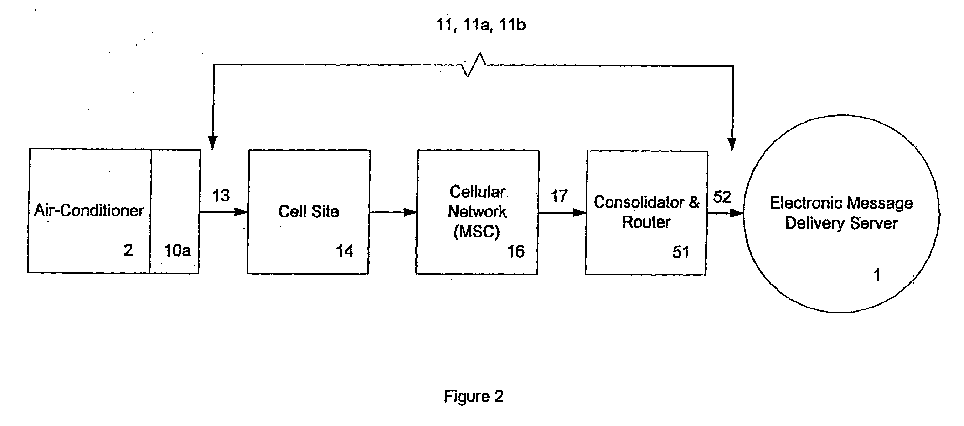

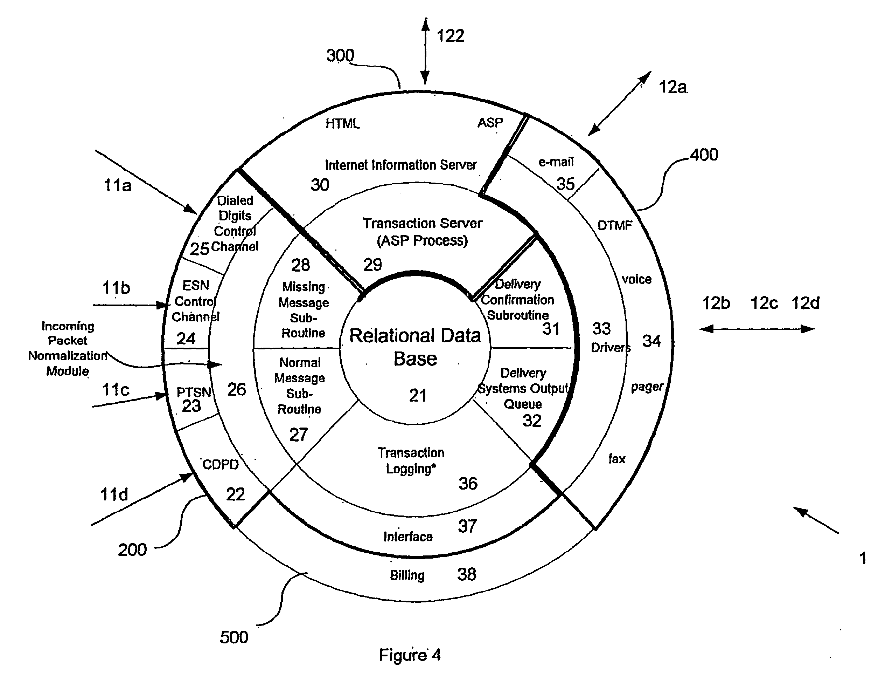

Messages from some of the interface units 10 may be delivered by means of wireless transmission over the cellular telephone network (see U.S. Pat. Nos. 5,594,740 and 5,546,444). FIG. 2 is a detailed view of link 11 shown in FIG. 1. A message is transmitted from the cellular interface unit 10a via a radio frequency link 13 to a nearby cellular transceiver site 14, the message is then routed to the cellular network or mobile switching center (MSC, e.g., a cellular carrier such as Bell Atlantic) 16 where the message is then delivered via data circuits 17 and via router 51 (e.g., Bell South Cellemetry or Aeris) to the message delivery server 1. As will be clear from the discussion of FIG. 4, reference numerals 11a and 11b refer to different types of links. Specifically, link 11a is for receiving incoming exception and status messages from interfaces 10 which are in regions wired for sending data via the dialed digits control channel; link 11b forwards messages along the ESN channel to the message server 1.

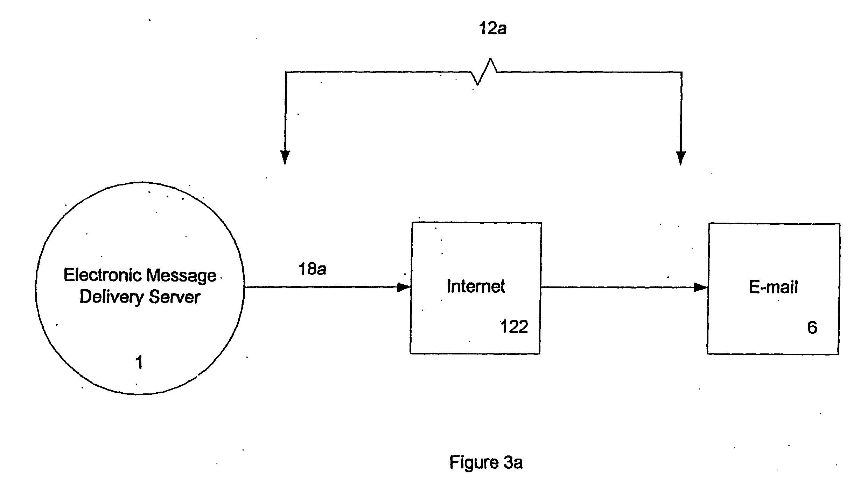

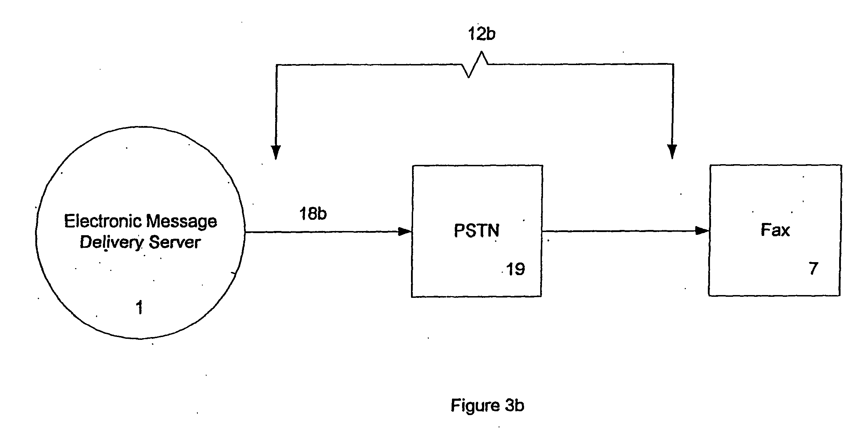

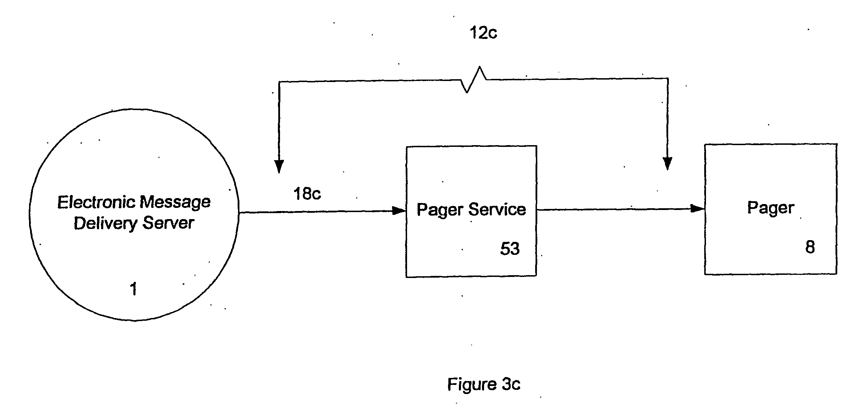

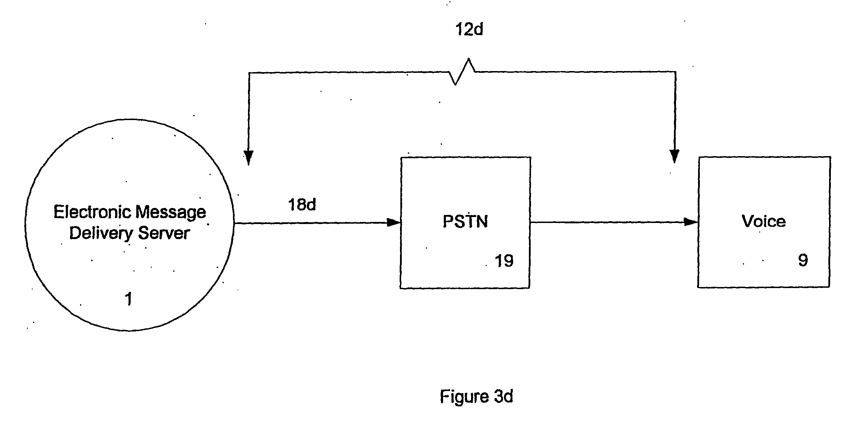

Based on the configuration of the user's message profile, the outgoing exception message (or messages) is then delivered to the specified end device or devices. FIGS. 3a-d show a more detailed view of the various outbound links 12a-d that connect the server 1 to the various electronic media. In FIG. 3a, server 1 sends the message over a telephone line 18a to the Internet 122 and deposits the message in the user's e-mail box 6. In FIG. 3b, server 1 sends the message over a telephone line 18b through the public telephone switched network (PTSN) 19 to the user's fax machine 7. In FIG. 3c, server 1 sends the message over a telephone line 18c to the user's pager service 53 and thence to the user's pager or PCS 8. In FIG. 3d, server 1 sends the message over a telephone line 18d through the PTSN 19 to the user's voice mail box 9. The same message may also be sent to a number of other devices as configured by the user 121 over the Internet 122. The same message that is being sent to a fax machine 7 as described above may also simultaneously be sent to an e-mail 6 recipient via the Internet. Preferably, different messages can be sent to different individuals simultaneously for the same fault condition; for example, the owner of the premises may receive a less-detailed message than the contractor.

A user's message profile can also be configured to store messages on server 1 for delivery at a later time or after certain conditions are met. For example, a contractor may not want his beeper activated every time server 1 receives an incoming exception message. The user profile can be configured to deliver messages on groups or only after several messages have accumulated for the same user/contractor. Optionally, an outgoing exception message may be generated only after several of the same type of incoming message are received; a portion of the memory of server 1 may be devoted to the storing and/or accumulating of messages. Alternatively, a single outgoing exception message may be generated in response to several incoming messages.

In the same way the user profile can be configured, the user can configure virtual dip switches to enable or disable certain error messages. Conventional hardwired dip switches must be adjusted on site at the remote equipment. Virtual dip switches are software subroutines stored in server 1 which allow the user to toggle on or off certain portions of the ladder logic of the PLCs controlling the sensors of the remote equipment. According to the invention, the user can go to a website on the Internet 122 and, through menu-driven commands, enable or disable sections of the ladder logic just as he would be able to by flipping conventional dip switches at the installation site of the remote equipment. Additionally, the user will be able to configure the logic of the PLC remotely via the Internet as well.

A user may also control the functioning of a remote device in this way, via the Internet. The user can enter commands at the website or other Internet interface, and those commands are forwarded to the server 1. In accordance with the user profile, for example, in the same way that exception messages are sent out via links 12a-d, a command message may be sent to the remote device through interface unit 10. Such command messages allow the user to activate, deactivate, and otherwise control the appliance. The interface unit 10 can receive these command messages because the means by which the unit 10 communicates with the server, e.g., the cellular telephone network, is bi-directional. As a result of this bi-directionality, incoming links 11a-d may also be used to communicate with the devices through their respective interface units 10.

FIGS. 4 and 8-15 show the details of the message delivery server 1. In the preferred embodiment, server 1 includes four hardware devices (separated by heavy lines) 200, 300, 400, and 500. Device 200 is responsible for receiving incoming messages, processing them in accordance with the user's preferences, and routing them for output. Messages may be temporarily stored or accumulated on device 200 before being transmitted to the user if the user's message profile is set up accordingly. Device 300 enables the user 121 to access server 1 and create or edit his message profile residing in relational data base 21 of device 200. Device 400 includes the various drivers 33 which are responsible for transmitting the various messages to the various media (fax, e-mail, etc.). Device 500 includes billing computer 38 for keeping track of the charges and fees associated with the user's use of the service. It should be understood that the specific portions of each hardware device need not be arranged in the precise configuration shown.

At the core of server 1 is a relational data base 21. Incoming messages are received by a specific service designed to handle both the transport method and message formatting. Every interface unit 10 is provided, like a cellular telephone, with an electronic serial number (ESN, to identify the specific interface unit sending the message) and a mobile identification number (MIN, similar to a cellular telephone's phone number). In some instances, the exception or status information is embedded in the dialed digits the interface transmits. The dialed digits control channel module 25 specifically receives messages that are encoded in the control channel's dialed digits (see U.S. Pat. No. 5,594,740). The ESN control channel module 24 receives messages that are encode in the electronic serial number of the message (U.S. Pat. No. 5,546,444). It is preferable to have both a dialed digits module 25 and an ESN module 24, because some geographic regions employ dialed digit data coding, while other regions employ ESN data coding. Information may be transmitted via the MIN of the interface 10 and also received by message delivery server 1. Services are also available to receive messages for analog modems connected to the public telephone switched network 23, and the cellular digital packet data network 22. As additional methods of transmitting data become available, they can be added to the services layer.

All incoming messages are normalized at the normalization module 26 so that all incoming messages can then be processed without regard to their incoming medium. All incoming messages are passed to the normal message subroutine 27, exception messages are passed on for processing and routing via the user's configuration through the data base 21, and periodic status messages are queued. The missing message subroutine 28 compares received status messages with a list of expected messages. Status messages that are not received have an error message generated by the missing message subroutine 28 which are then delivered as configured by the user in his message profile as recorded in the relational database 21.

Messages to be delivered are placed in a message queue 32; as message traffic permits the appropriate drivers 33 request messages from the message queue 32 and route the messages over the appropriate transport. Numeric pages, faxes, voice and DTMF 34 are sent over the PTSN 12b-d, e-mail 35 is sent over the Internet 122. When a driver 33 has successfully delivered, a record is made in the data base 21 by the delivery confirmation subroutine 31 showing time and date of successful deliveries. Undeliverable messages are routed back to the database for generation of undeliverable message errors.

Users 121 connect to an Internet information server 30 via the Internet 122. The Internet information server presents to the user the information pertaining to that user's interfaces. Requests to alter the user's data are passed through active server pages 29 to protect both the integrity and security of the data base 21. All messages and transactions that pass through the system are logged in section 36, the transaction and message logs are then interfaced by section 37 to a billing system 38.

A portion of the memory in relational data base 21 is preferably used to compile data regarding the devices being monitored over time. Such data is sortable by any number of different criteria, including brand of equipment, specific models of equipment, installation date (and thus the age of the equipment), the general local climate in which the equipment is installed (e.g., arid, humid, warm, rainy, etc.), local weather conditions in a given period of time, and the like. This information is usable in a number of different ways. A user can log in via the Internet, for example, and find out the maintenance history of his specific units to see which are the most reliable or most unreliable. Alternatively, a user can check to see which brands or models generally are the most reliable for any given conditions (age, climate, weather, etc.). Additionally, the information may be collated and processed by the operator of data base 21 and published by any number of different criteria. Any of the various messages may be stored for this purpose, e.g., the incoming messages from the interface units, the normalized messages output from the normalization module, the outgoing messages, normal status messages, etc.

An example of the system's operation from the perspective of the user-contractor is as follows. When a user-contractor 121 first signs up with the system 50, he receives an account on the electronic message delivery server 1. Via the Internet, the contractor 121 is prompted through software to enter the pager numbers, cellular telephone numbers, facsimile machine numbers, and Internet addresses of any individuals who are to be contacted in the event of an exception condition in building equipment 2-5 for which the contractor is responsible. The user-contractor 121 may also set the software to notify him of the periodic successful routine status check messages conveyed from equipment 2-5.

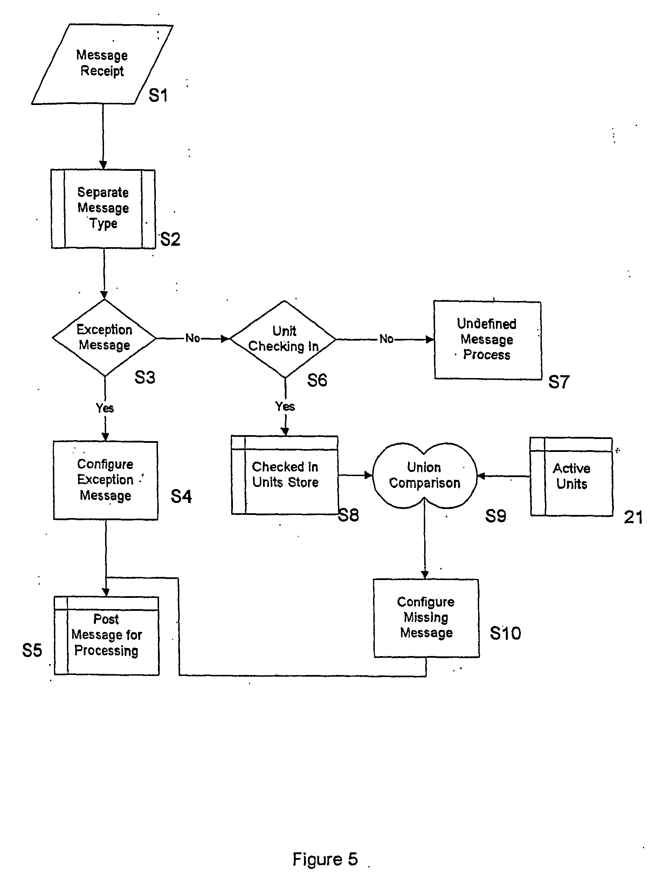

FIG. 5 depicts a flow chart of the basic steps that occur when a message is received by server 1. At step S1, the message is received. At step S2, normalization module 26 removes the required elements from the incoming message and arranges them in a normalized format and stores them as a record in a table. Server 1 can now examine a specific element in a message of any received media type. At step S3, it is determined what type of error message has been received. If it is an exception message that requires immediate action, it is passed onto a process to begin configuration of a readable message at step S4 for delivery at step S5. If not, server 1 determines if the received message is a "unit checking in" or a "system ok" status message at step S6. If the user has his message profile so configured, a storing/accumulating step (not shown) may occur between steps S4 and S5. Undefined messages are handled at step S7. If it is configured as a periodic message received to indicate normal operation of a unit, the message is stored at step S8 for use at a later time. Periodically, the list of units that have reported in at step S8 and the list of active units expected to report in (part of database 21) are compared at step S9. Units on the active list that do not appear on the checked-in units list are processed, and units that failed to report in have messages created at step S10. These messages are then posted for further processing and message delivery at step S5.

In the example given, suppose boiler 3 breaks down in a non-catastrophic manner. The fault condition is detected by a sensor (not shown) and encoded to interface 10. Interface 10 transmits a radio message via link 13 to a local cell site 14, which contacts data circuits 17 via cellular network 16. Circuits 17 forward the message to message server 1. If the message is transmitted by the cellular telephone network 16, the ESN arrives via link 11b to ESN channel 24; alternatively, the dialed digits information arrives via link 11 a to dialed digits channel 25.

The message is normalized in normalization module 26 and passed along to the normalized message process module 27. Module 27 selects the user's message profile from relational database 21 and in accordance therewith, determines what message gets sent to whom and by which medium. Alternatively or in addition, multiple fault conditions may be linked together via user-configurable ladder logic.

The above explanation was a "user's-eye" view of the macroscopic workings of the inventive system. Additional details concerning some of the inner workings of the preferred embodiment follow. In no way should these details be construed as being limiting of the scope of the invention.

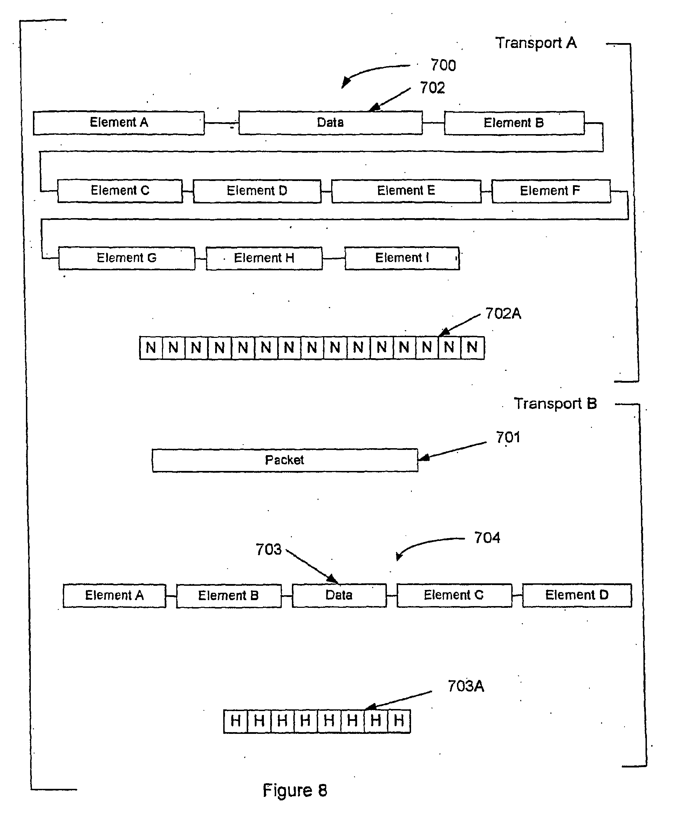

There are many available methods of transporting data; one of the objectives of the invention is thus to use various transport methods and have the received data normalized so the subsequent processes will not be effected by the transport method. FIG. 4 shows data being received in a variety of formats via links 11a-d by device 200. FIG. 8 illustrates two exemplary data transport formats receivable by device 200. A message received from the first transport, "Transport A," is received in the form of a string 700 of information packets having data packet 702. Data packet 702 is the message forwarded to the server by interface unit 10. This particular transport delivers the message in the form of fifteen decimal digits as shown by exemplary data packet 702A.

A different exemplary transport, "Transport B," is shown in FIG. 8 below Transport A. In Transport B, a single packet 701 is received. The single packet is parsed into elements which include a data element 703. An exemplary data element 703A is shown to include eight hexadecimal digits. One of the functions of the system is to be able to accept a wide variety of information formats not just limited to as described above, with Transport A delivering the data in the form of fifteen decimal digits and Transport B delivering the data in the form of eight hexadecimal digits.

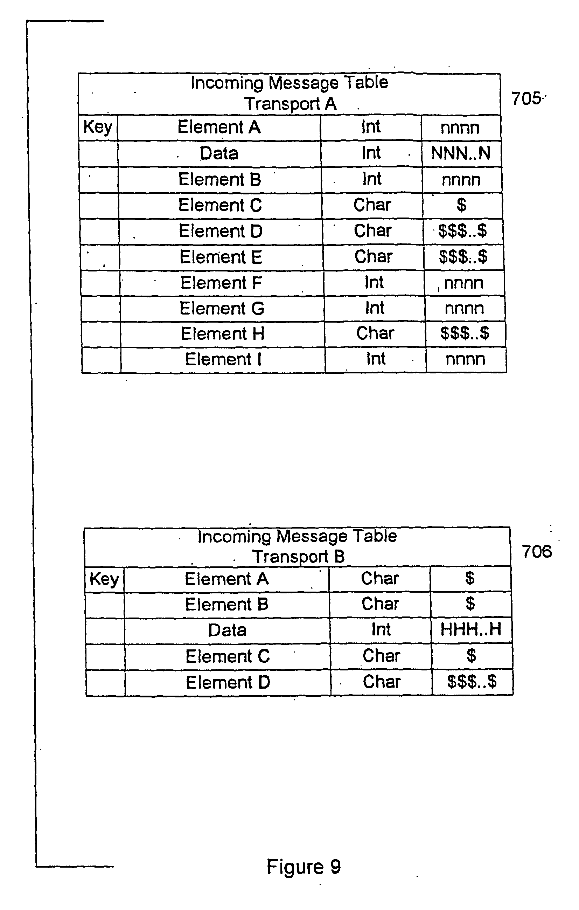

On relational data base 21, a number of tables are provided, at least one for each transport, into which the received data is deposited. FIG. 9 shows the tables on data base 21 that are loaded with the data received from Transports A and B; Incoming Message Transport A Table 705 receives data elements 702 from Transport A, and Incoming Message Transport B Table 706 receives data elements 703 from Transport B. A standard data base command is used to insert the data into the next available row in the appropriate table when a data message is received from a transport. Incidentally, the central data base 21 may be provided with and use a conventional off-the-shelf data base processor such as SQL7 sold by Microsoft.

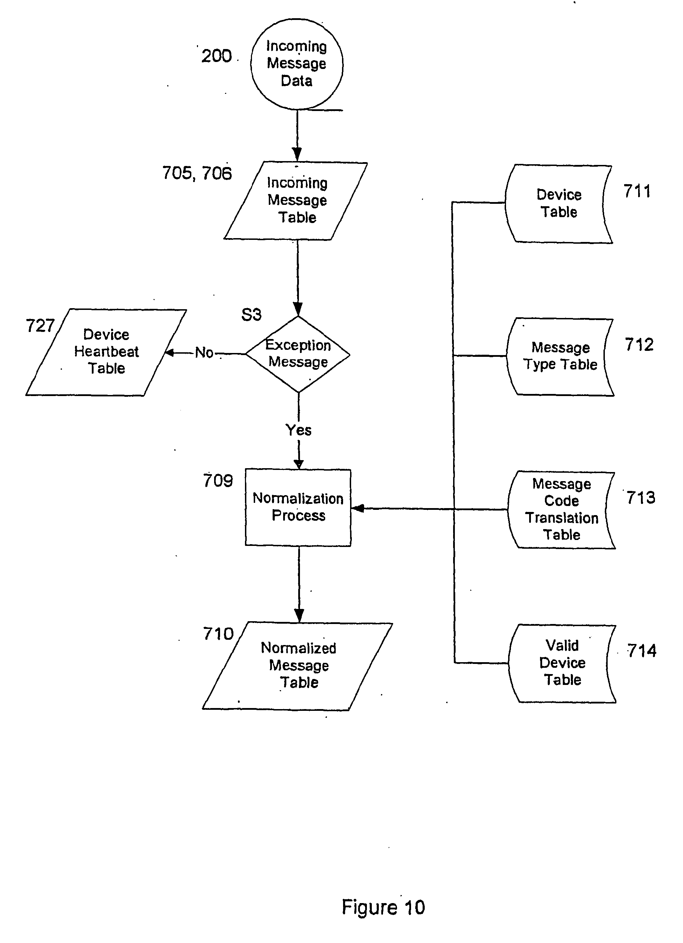

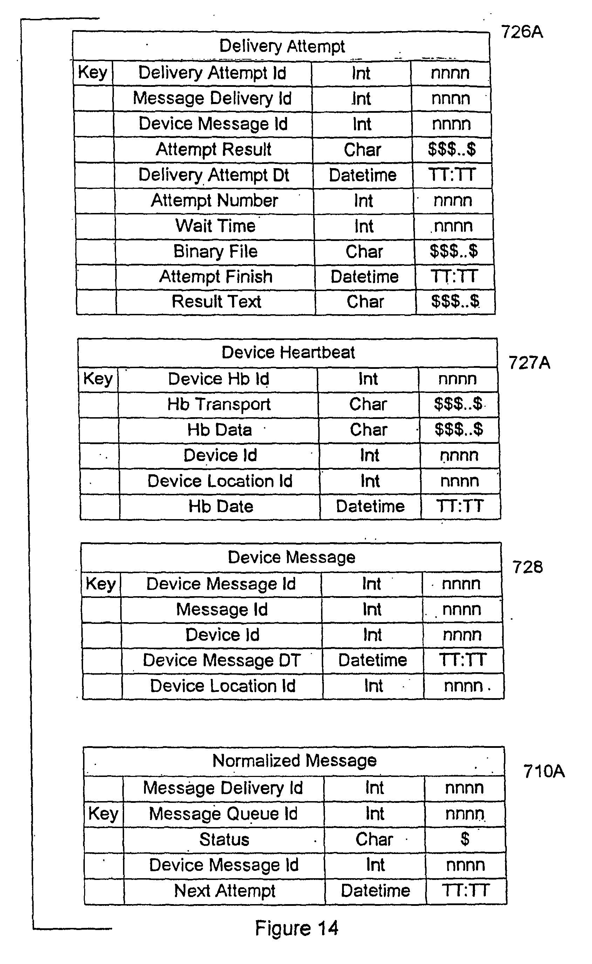

FIG. 10 shows the flow of data for a typical transport. All of the elements shown on FIG. 10 are required for each of the transports with the exception of the Normalized Message Table 710, which is the common table that all received exception messages are deposited into for further processing. The particular interface to a transport is represented generally as device 200, which includes the aforementioned control channels 22-25. Device 200 places the next incoming message from the transport into the corresponding Incoming Message Table 708 by utilizing the database's add row function. The Incoming Message Table 708 maintains the history of all messages received from a transport. When a row is added to the Incoming Message Table 708, the system determines at Step S3 (also see FIG. 5) whether the received message is an exception message or a normal status or "heartbeat" message. If the received message is normal status message, a row containing the received message data is added to the Device Heartbeat Table 727. A detail of the recorded heartbeat elements is shown on FIG. 14 as exemplary table 727A.

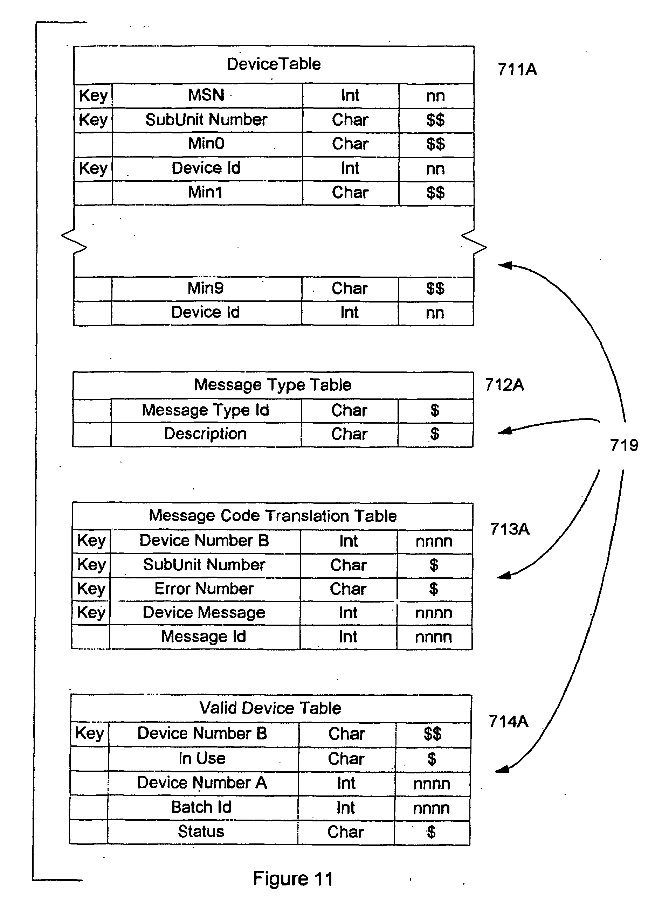

If it is determined at Step S3 that the row added to the Incoming Message Table is an exception message, the Normalization Process 709 references a group of data tables 711-714 to validate the received message and translate the exception message from its original format that was best suited for the transport. Data tables 711-714 are provided on data base 21. Each transport requires its own set of data tables. For example, as shown in FIG. 11, tables 711A-714A correspond to Transport A; similar tables (not shown) would be provided for Transport B and any other transports utilized by the system. Device Table 711 is a list of devices manufactured for the transport, Valid Device Table 714 contains a list of devices that have been activated, Message Type Table 712 and Message Code Translation Table 713 are used to form the normalized message that is added to the Normalized Message Table 710. The Normalized Message Table 710 is a single table to which the respective Normalization Processes of all transports adds a row. The Normalization Process is the logical equivalent of normalization module 26 and normal message subroutine 27 of FIG. 4.

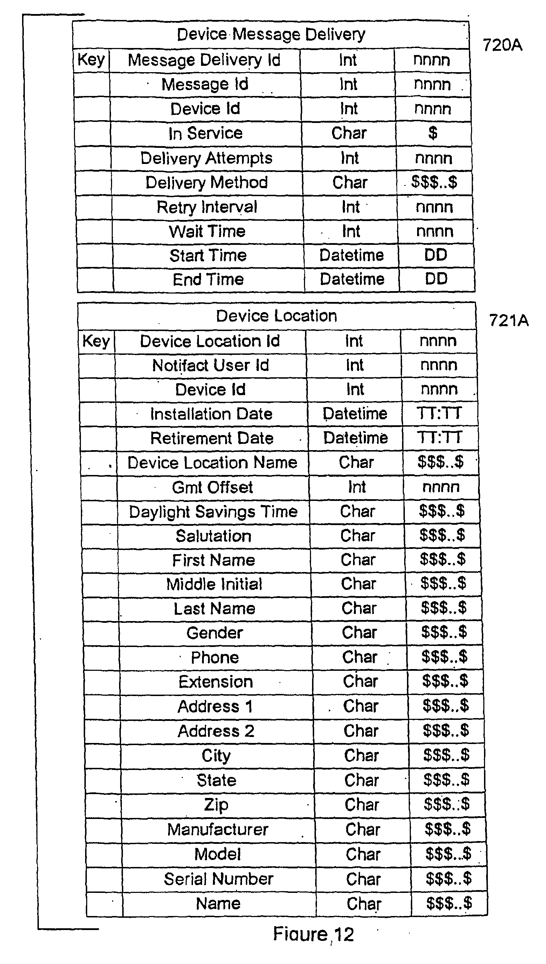

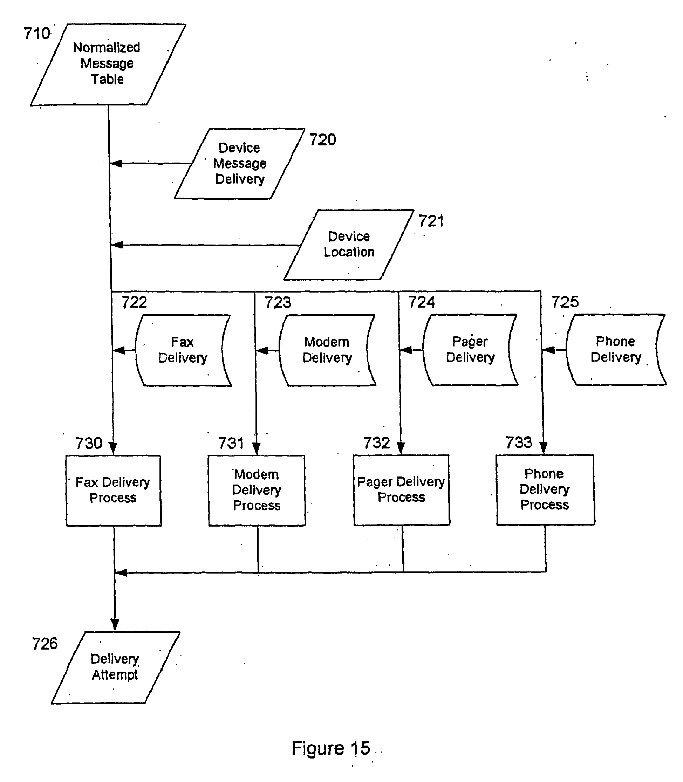

FIG. 15 shows the flow of data after a message is deposited into the message queue 32 (see FIG. 4) pending delivery. The Normalized Message Table 710 functions as this queue. When an exception message is added as a row to this queue, a look-up operation is performed in the Device Message Delivery Table 720 (shown in detail in FIG. 12) for all message deliveries that pertain to the exception message pending delivery. Device Message Delivery Table 720 is a table of all delivery methods for all outgoing messages that potentially can be sent. Details of the Device Message Delivery Table 720A contains the information on, how many delivery attempts should be made for a particular message, by what method the delivery should be made, how many times this attempt should be made, how long to wait between attempts, and during what periods of time a message should be sent. Each delivery method i.e. Fax Delivery, Modem Delivery, Pager Delivery, Phone Delivery, etc. has a corresponding delivery process 730-733 and message table 722-725. For example, The Fax Delivery process 730 contains the required hardware and software to interface to the Public Switched Telephone Network (PSTN) and send a fax transmission to fax equipped receiver. The Fax Delivery table 722 contains the actual message to be sent to a fax receiver for each potential fax message. Each delivery process adds a row to the Delivery Attempt table 726 with the result of a delivery attempt. A successful or failed fax delivery is indicated in the table by the addition of a row by the result returned from the fax hardware interface indicating the delivery result. The telephone delivery process utilizes a text to speech synthesizer to speak the message text to the person who answers the telephone call. Confirmation of deliver is established by the system requesting the person who is receiving the message to make certain actions such as press certain buttons on a touch tone telephone to acknowledge the receipt of the message. Acknowledgment or not is recorded by the Phone Delivery process 733 in the Delivery Attempt table 726.

It can be seen that the previously described user-defined message profile is not a discrete set of instructions that are all stored together, although it would appear so from the user interface, e.g., the website maintained by server 30. Rather, a user's message profile includes multiple elements, each of which is placed on a different table according to the type of data it represents. All of the user's respective delivery instructions are stored on Device Message Delivery Table 720. All of the user's respective facsimile delivery instructions are stored on Fax Delivery Table 722. All of the user's respective pager delivery instructions are stored on table 724. Each entry is identifiable by the "Key" associated therewith, as shown in the various tables of FIGS. 12-14.

The data engine (e.g., SQL 7) selects the next available row in the Normalized Message Table 710. Utilizing the Message Delivery ID, it then selects all records with the same Message Delivery ID in the Device Message Delivery Table 720. The resulting selection list is sorted by Delivery Method and those records that meet the selection criteria for message delivery time, and in service are prepared for message delivery. Each delivery process 730-733 polls the data engine to see if a message is available for delivery in the Device Message Delivery Table 720 with a delivery method that is suitable for its delivery function. If a delivery method is available to be sent the delivery process, for example a fax, the fax delivery process 730 will select the corresponding user defined message for the exception message to be sent from the Fax Delivery Table 722 along with the equipment location, make model, and serial number found in the Device Location Table 721. The delivery process then attempts to send the message to the user defined address found in the delivery table, for example, the fax number found in Fax Delivery table 722.

Each deliverable message is configurable by the user simply by editing the message text found in the delivery tables 722-725. Multiple deliveries are accomplished by having multiple delivery records in the delivery tables 722-725 with the same Message Delivery ID each having a unique delivery address i.e. fax number, phone number, etc. Additional delivery methods are easily added to the system by adding a new delivery transport process and an associated delivery table.

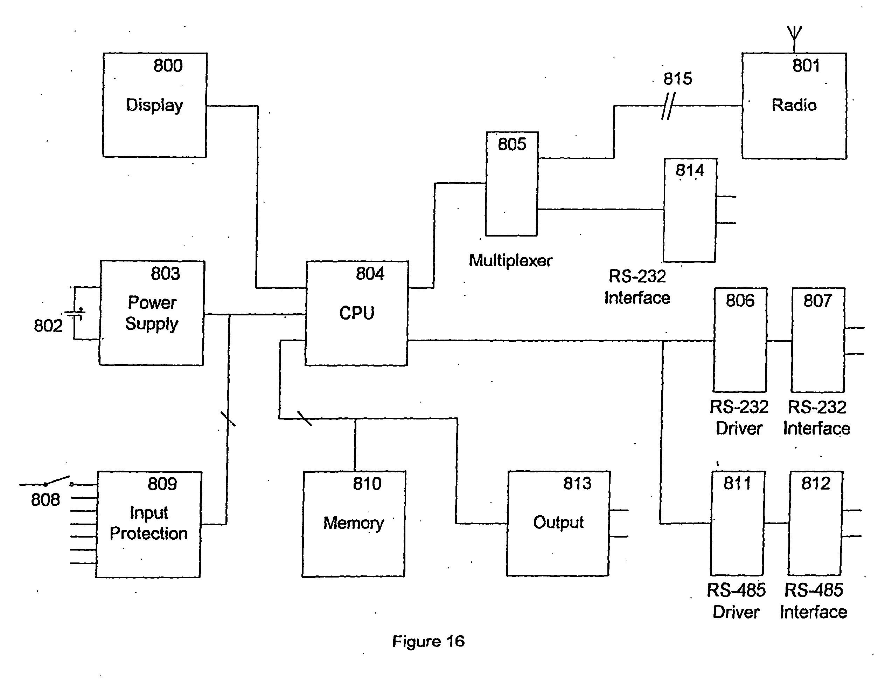

FIG. 16 illustrates the remote interface unit (RIU) 10 used to send messages to the remote server. The RIU contains a removable module capable of sending messages to the server over a specific transport shown here as a two way radio 801. The RIU 10 can be connected to a monitored piece of equipment in several ways. An array of inputs 808 can be wired into the monitored piece of equipment's limit, operating and auxiliary sensors. Alternatively or in addition, the RIU 10 can be connected to the monitored equipment's communication interface if equipped by the equipment manufacture via a serial interface 807 or 812.

The central processing unit (CPU) 804 is preferably an industry standard 8-bit microcontroller with 3 general purpose input/output (IO) ports and 2 serial ports. The first IO port is connected to a display 800 that is used to indicate operating modes and conditions of the RIU 10 to a person installing, testing, or servicing the RIU. The second port is in communication with both the monitored equipment and the RIU's power supply. This port of the CPU is buffered and protected by filter 809 which uses standard filter arrangements from unwanted surges and voltage transients that may be present on the sensing devices 808 connected to the RIU. The port is also in communication with the RIU's internal power supply 803. CPU 804 is capable of operating the power supply 803 on and off in order to perform standby battery 802 tests, monitor the presence of line power, and use the frequency of the line power to maintain a time standard. The third 10 port is used to connect additional memory 810 to the CPU 804 and to operate output drivers 813, which are typically in the form of relays. The state of the outputs can either be determined by results of decisions made within the CPU 804 or commands received from the remote server via the transport radio 801.

The CPU has two serial interface ports, the first port is connected to a multiplexer 805 that is used to steer the flow of serial data either to the transport radio module 801 or an internal interface 814 used to configure the RIU during manufacturing, testing, and subsequent configuration changes. The transport radio module 801 is connected to the multiplexer 805 via a connector 815; this enables different radio transports to be installed at the manufacture to enable the use of a particular transport best suited for an application. Factors that may effect the transport selection are quantity of data to be sent to the remote server, and wireless networks deployed i.e. control channel over AMP, or CDPD. The second serial interface is connected in parallel to both an RS-232 driver 806 and a RS-485 driver 811, with the respective driver being connected to an interface device, RS-232807 and RS-485812. Different equipment manufactures use different interface schemes on their equipment, some use RS-232 and some RS-485. For that reason, the RIU supports both. When one of these interfaces is used to communicate with a piece of equipment's communication port, all internal data maintained by the equipment's internal CPU may be available to the RIU for transmission to the remote sever. Sensing devices 808 may also be connected to the CPU 804 via the input protection circuit 809 when the RS-232807 or RS-485812 are used to communicate with the monitored equipment. Together, CPU 804, multiplexer 805, and radio 801 make up the message generating mechanism of interface unit 10 discussed above.

Once every 24 hours, the CPU assembles a packet (heartbeat) of data which contains status and operational data of connected monitored equipment and communicates this packet of data to the transport radio module 801. The transport radio module 801 then transmits the information to the remote server as a normal status message as explained above. The CPU 804 also monitors the status of the sensing devices 808. The state of these inputs is feed into a virtual Programmable Logic Controller (v-PLC) running within the CPU 804. The resultant relay outputs of the v-PLC can cause the CPU 804 to assemble an exception message packet and pass it on to the transport radio 801 for delivery to the remote server.

The invention is not limited to the above description but rather is defined by the claims appearing herein below. Modifications to the above description that include that which is known in the art are well within the scope of the contemplated invention. For example, the invention is designed to be adaptable to all forms of electronic communication, be they cellular telephone, land line telephone, electronic mail, facsimile, text page, voice mail, etc. All forms of electronic media are contemplated as being within the scope of the invention. Also, multiple formats of incoming and outgoing messages are contemplated as included within the scope of the claims and the invention. The user can adjust the format and content of the messages he receives by setting up his message profile accordingly. The invention is also not limited to use in monitoring HVAC equipment but is contemplated to be useful for maintaining all forms of remote equipment. For example, the inventive system and method would prove extremely expedient is monitoring and replacing warning lights on cellular towers, radio transmitter towers, and other remote structures.

## Claims

1. A method for controlling one or more of resource-consumption and resource-production associated with a plurality of remote devices, the method comprising the steps of:
automatically generating at least one informational message at a central server responsive to one or more of resource-consumption by, resource-production by, operating characteristics of, and operational state of at least one device of the plurality of remote devices; and
transmitting the at least one informational message to at least one communication device, where the at least one communication device enables the taking of at least one action having the effect of providing a change of one or more of resource-consumption, resource-production, operating characteristics, and operational state, attributed to the at least one device of the plurality of remote devices wherein at least one predetermined rule is related to controlling the at least one device.

2. The method of claim 1, wherein the at least one predetermined rule is defined by a user associated with the plurality of remote devices.

3. The method of claim 1, wherein the at least one predetermined rule is defined at a user interface via the Internet.

4. The method of claim 1, wherein the at least one predetermined rule is stored in a user profile associated with a user.

5. The method of claim 1, wherein the at least one predetermined rule comprises one or more situational rules where each situational rule is applicable for an identified circumstance.

6. The method of claim 1, wherein the at least one predetermined rule comprises a predetermined rule specific for the plurality of remote devices.

7. The method of claim 1, wherein the at least one predetermined rule varies in accordance with feedback data.

8. The method of claim 7, wherein the at least one predetermined rule varies situationally.

9. The method of claim 7, wherein the at least one predetermined rule varies dynamically.

10. The method of claim 1, wherein the at least one informational message is generated in accordance with the at least one predetermined rule.

11. The method of claim 10, wherein the at least one predetermined rule is directed to controlling one or more of one or more of state, use, one or more parameters, one or more set points, operating characteristics, duty cycle, control logic and scheduling of the plurality of remote devices.

12. The method of claim 11, wherein the at least one predetermined rule identifies how the plurality of remote devices are monitored.

13. The method of claim 11, wherein the user defined rules comprise multiple levels of control or adjustment concerning the plurality of remote devices.

14. A system for controlling one or more of resource-consumption and resource-production associated with a plurality of remote devices, the system comprising:
a central server that automatically generates at least one informational message responsive to one or more of resource-consumption by, resource-production by, operating characteristics of, and operational state of at least one device of the plurality of remote devices; and
a communication link that transmits the at least one informational message to at least one communication device, where the at least one communication device enables the taking of at least one action having the effect of providing a change of one or more of resource-consumption, resource-production, operating characteristics, and operational state attributed to the at least one device wherein at least one predetermined rule is related to controlling the at least one device.

15. The system of claim 14, wherein the at least one predetermined rule is defined by a user associated with the plurality of remote devices.

16. The system of claim 14, wherein the at least one predetermined rule is defined at a user interface via the Internet.

17. The system of claim 14, wherein the at least one predetermined rule is stored in a user profile associated with a user.

18. The system of claim 14, wherein the at least one predetermined rule comprises one or more situational rules where each situational rule is applicable for an identified circumstance.

19. The system of claim 14, wherein the at least one predetermined rule comprises a predetermined rule specific for the plurality of remote devices.

20. The system of claim 14, wherein the at least one predetermined rule varies in accordance with feedback data.

21. The system of claim 20, wherein the at least one predetermined rule varies situationally.

22. The system of claim 20, wherein the at least one predetermined rule varies dynamically.

23. The system of claim 14, wherein the at least one informational message is generated in accordance with the at least one predetermined rule.

24. The system of claim 23, wherein the at least one predetermined rule is directed to controlling one or more of one or more of state, use, one or more parameters, one or more set points, operating characteristics, duty cycle, control logic and scheduling of the plurality of remote devices.

25. The system of claim 24, wherein the at least one predetermined rule identifies how the plurality of remote devices are monitored.

26. The system of claim 24, wherein the user defined rules comprise multiple levels of control or adjustment concerning the plurality of remote devices.

## Patentansprüche

1. Verfahren zur Steuerung eines oder mehrerer von Ressourcenverbrauch und Ressourcenerzeugung, der bzw. die mit einer Mehrzahl von entfernten Vorrichtungen in Verbindung steht, wobei das Verfahren umfasst:
Automatisches Erzeugen mindestens einer Informationsnachricht an einem zentralen Server als Reaktion auf eine oder mehrere von Ressourcenverbrauch, Ressourcenerzeugung, Betriebscharakteristiken und Betriebszustand von mindestens einer Vorrichtung der Mehrzahl der entfernten Vorrichtungen; und
Übertragen der mindestens einen Informationsnachricht zu mindestens einer Kommunikationsvorrichtung, wobei die mindestens eine Kommunikationsvorrichtung das Ergreifen mindestens einer Maßnahme ermöglicht, die die Bereitstellung einer Veränderung eines oder mehrerer von Ressourcenverbrauch, Ressourcenerzeugung, Betriebscharakteristiken und Betriebszustand bewirkt, die der mindestens einen Vorrichtung der Mehrzahl der entfernten Vorrichtungen zugeordnet ist, wobei mindestens eine vorher festgelegte Regel mit der Steuerung der mindestens einen Vorrichtung in Verbindung steht.

2. Verfahren nach Anspruch 1, wobei die mindestens eine vorher festgelegte Regel von einem Benutzer definiert ist, der mit der Mehrzahl der entfernten Vorrichtungen in Verbindung steht.

3. Verfahren nach Anspruch 1, wobei die mindestens eine vorher festgelegte Regel über das Internet an einer Benutzerschnittstelle definiert ist.

4. Verfahren nach Anspruch 1, wobei die mindestens eine vorher festgelegte Regel in einem Benutzerprofil gespeichert ist, das mit einem Benutzer in Verbindung steht.

5. Verfahren nach Anspruch 1, wobei die mindestens eine vorher festgelegte Regel eine oder mehrere situationsbezogene Regeln umfasst, wobei jede situationsbezogene Regel für einen bestimmten Umstand gilt.

6. Verfahren nach Anspruch 1, wobei die mindestens eine vorher festgelegte Regel eine vorher festgelegte Regel umfasst, die für die Mehrzahl der entfernten Vorrichtungen spezifisch ist.

7. Verfahren nach Anspruch 1, wobei die mindestens eine vorher festgelegte Regel in Abhängigkeit von Feedbackdaten variiert.

8. Verfahren nach Anspruch 7, wobei die mindestens eine vorher festgelegte Regel mit der Situation variiert.

9. Verfahren nach Anspruch 7, wobei die mindestens eine vorher festgelegte Regel dynamisch variiert.

10. Verfahren nach Anspruch 1, wobei die mindestens eine Informationsnachricht in Abhängigkeit von der mindestens einen vorher festgelegten Regel erzeugt wird.

11. Verfahren nach Anspruch 10, wobei die mindestens eine vorher festgelegte Regel auf die Steuerung eines oder mehrerer Zustände, Verwendung, eines oder mehrerer Parameter, eines oder mehrerer Sollwerte, Betriebscharakteristiken, Tastgrad, Steuerlogik und Planung der Mehrzahl der entfernten Vorrichtungen vorgesehen ist.

12. Verfahren nach Anspruch 11, wobei die mindestens eine vorher festgelegte Regel festlegt, wie die Mehrzahl der entfernten Vorrichtungen überwacht wird.

13. Verfahren nach Anspruch 11, wobei die benutzerdefinierten Regeln mehrere Niveaus für Steuerung oder Einstellung der Mehrzahl der entfernten Vorrichtungen umfassen.

14. System zur Steuerung eines oder mehrerer von Ressourcenverbrauch und Ressourcenerzeugung, der bzw. die mit einer Mehrzahl von entfernten Vorrichtungen in Verbindung stehen, wobei das System umfasst:
einen zentralen Server, der als Reaktion auf eine oder mehrere von Ressourcenverbrauch, Ressourcenerzeugung, Betriebscharakteristiken und Betriebszustand von mindestens einer Vorrichtung der Mehrzahl der entfernten Vorrichtungen automatisch mindestens eine Informationsnachricht erzeugt; und
eine Kommunikationsverbindung, die die mindestens eine Informationsnachricht zu mindestens einer Kommunikationsvorrichtung überträgt, wobei die mindestens eine Kommunikationsvorrichtung das Ergreifen mindestens einer Maßnahme ermöglicht, die die Bereitstellung einer Veränderung eines oder mehrerer von Ressourcenverbrauch, Ressourcenerzeugung, Betriebscharakteristiken und Betriebszustand bewirkt, die der mindestens einen Vorrichtung zugeordnet ist, wobei mindestens eine vorher festgelegte Regel mit der Steuerung der mindestens einen Vorrichtung in Verbindung steht.

15. System nach Anspruch 14, wobei die mindestens eine vorher festgelegte Regel von einem Benutzer definiert ist, der mit der Mehrzahl der entfernten Vorrichtungen in Verbindung steht.

16. System nach Anspruch 14, wobei die mindestens eine vorher festgelegte Regel über das Internet an einer Benutzerschnittstelle definiert ist.

17. System nach Anspruch 14, wobei die mindestens eine vorher festgelegte Regel in einem Benutzerprofil gespeichert ist, das mit einem Benutzer in Verbindung steht.

18. System nach Anspruch 14, wobei die mindestens eine vorher festgelegte Regel eine oder mehrere situationsbezogene Regeln umfasst, wobei jede situationsbezogene Regel für einen bestimmten Umstand gilt.

19. System nach Anspruch 14, wobei die mindestens eine vorher festgelegte Regel eine vorher festgelegte Regel umfasst, die für die Mehrzahl der entfernten Vorrichtungen spezifisch ist.

20. System nach Anspruch 14, wobei die mindestens eine vorher festgelegte Regel in Abhängigkeit von Feedbackdaten variiert.

21. System nach Anspruch 20, wobei die mindestens eine vorher festgelegte Regel mit der Situation variiert.

22. System nach Anspruch 20, wobei die mindestens eine vorher festgelegte Regel dynamisch variiert.

23. System nach Anspruch 14, wobei die mindestens eine Informationsnachricht in Abhängigkeit von der mindestens einen vorher festgelegten Regel erzeugt wird.

24. System nach Anspruch 23, wobei die mindestens eine vorher festgelegte Regel auf die Steuerung eines oder mehrerer Zustände, Verwendung, eines oder mehrerer Parameter, eines oder mehrerer Sollwerte, Betriebscharakteristiken, Tastgrad, Steuerlogik und Planung der Mehrzahl der entfernten Vorrichtungen vorgesehen ist.

25. System nach Anspruch 24, wobei die mindestens eine vorher festgelegte Regel festlegt, wie die Mehrzahl der entfernten Vorrichtungen überwacht wird.

26. System nach Anspruch 24, wobei die benutzerdefinierten Regeln mehrere Niveaus für Steuerung oder Einstellung der Mehrzahl der entfernten Vorrichtungen umfassen.

## Revendications

1. Méthode destinée à contrôler au moins l'un des éléments suivants : consommation de ressources et production de ressources associées à une pluralité de dispositifs à distance, la méthode comprenant les étapes suivantes :
génération automatique d'au moins un message d'information au niveau d'un serveur central en réponse à au moins l'un des éléments suivants : consommation de ressources, production de ressources, caractéristiques de fonctionnement et état de fonctionnement d'au moins un dispositif parmi la pluralité de dispositifs à distance ; et
transmission de l'au moins un message d'information à au moins un dispositif de communication, où l'au moins un dispositif de communication permet de réaliser au moins une action ayant pour effet de modifier au moins l'un des éléments suivants : consommation de ressources, production de ressources, caractéristiques de fonctionnement et état de fonctionnement, attribué à l'au moins un dispositif parmi la pluralité de dispositifs à distance, où au moins une règle prédéterminée concerne le contrôle de l'au moins un dispositif.

2. La méthode de la revendication 1, où l'au moins une règle prédéterminée est définie par un utilisateur associé à la pluralité de dispositifs à distance.

3. La méthode de la revendication 1, où l'au moins une règle prédéterminée est définie au niveau d'une interface utilisateur via Internet.

4. La méthode de la revendication 1, où l'au moins une règle prédéterminée est mémorisée dans un profil utilisateur associé à un utilisateur.

5. La méthode de la revendication 1, où l'au moins une règle prédéterminée comprend au moins une règle situationnelle où chaque règle situationnelle est applicable dans une circonstance définie.

6. La méthode de la revendication 1, où l'au moins une règle prédéterminée comprend une règle prédéterminée spécifique pour la pluralité de dispositifs à distance.

7. La méthode de la revendication 1, où l'au moins une règle prédéterminée varie en fonction d'un retour de données.

8. La méthode de la revendication 7, où l'au moins une règle prédéterminée varie en fonction de la situation.

9. La méthode de la revendication 7, où l'au moins une règle prédéterminée varie de façon dynamique.

10. La méthode de la revendication 1, où l'au moins un message d'information est généré en fonction de l'au moins une règle prédéterminée.

11. La méthode de la revendication 10, où l'au moins une règle prédéterminée est destinée à contrôler au moins l'un des éléments suivants : au moins un état, utilisation, au moins un paramètre, au moins une valeur de consigne, caractéristiques de fonctionnement, rapport cyclique, logique de commande et planification de la pluralité de dispositifs à distance.

12. La méthode de la revendication 11, où l'au moins une règle prédéterminée définit la façon de surveiller la pluralité de dispositifs à distance.

13. La méthode de la revendication 11, où les règles définies par l'utilisateur comprennent plusieurs niveaux de contrôle ou de réglage concernant la pluralité de dispositifs à distance.

14. Système destiné à contrôler au moins l'un des éléments suivants : consommation de ressources et production de ressources associées à une pluralité de dispositifs à distance, le système comprenant :
un serveur central générant automatiquement au moins un message d'information en réponse à au moins l'un des éléments suivants : consommation de ressources, production de ressources, caractéristiques de fonctionnement et état de fonctionnement d'au moins un dispositif parmi la pluralité de dispositifs à distance ; et
une liaison de communication qui transmet l'au moins un message d'information à au moins un dispositif de communication, où l'au moins un dispositif de communication permet de réaliser au moins une action ayant pour effet de modifier au moins l'un des éléments suivants : consommation de ressources, production de ressources, caractéristiques de fonctionnement et état de fonctionnement, attribué à l'au moins un dispositif, où au moins une règle prédéterminée concerne le contrôle de l'au moins un dispositif.

15. Le système de la revendication 14, où l'au moins une règle prédéterminée est définie par un utilisateur associé à la pluralité de dispositifs à distance.

16. Le système de la revendication 14, où l'au moins une règle prédéterminée est définie au niveau d'une interface utilisateur via Internet.

17. Le système de la revendication 14, où l'au moins une règle prédéterminée est mémorisée dans un profil utilisateur associé à un utilisateur.

18. Le système de la revendication 14, où l'au moins une règle prédéterminée comprend au moins une règle situationnelle où chaque règle situationnelle est applicable dans une circonstance définie.

19. Le système de la revendication 14, où l'au moins une règle prédéterminée comprend une règle prédéterminée spécifique pour la pluralité de dispositifs à distance.

20. Le système de la revendication 14, où l'au moins une règle prédéterminée varie en fonction d'un retour de données.

21. Le système de la revendication 20, où l'au moins une règle prédéterminée varie en fonction de la situation.

22. Le système de la revendication 20, où l'au moins une règle prédéterminée varie de façon dynamique.

23. Le système de la revendication 14, où l'au moins un message d'information est généré en fonction de l'au moins une règle prédéterminée.

24. Le système de la revendication 23, où l'au moins une règle prédéterminée est destinée à contrôler au moins l'un des éléments suivants : au moins un état, utilisation, au moins un paramètre, au moins une valeur de consigne, caractéristiques de fonctionnement, rapport cyclique, logique de commande et planification de la pluralité de dispositifs à distance.

25. Le système de la revendication 24, où l'au moins une règle prédéterminée définit la façon de surveiller la pluralité de dispositifs à distance.

26. Le système de la revendication 24, où les règles définies par l'utilisateur comprennent plusieurs niveaux de contrôle ou de réglage concernant la pluralité de dispositifs à distance.
